Europäisches Patentamt

European Patent Office

Office européen des brevets

(19)

(11) **EP 1 646 079 A1**

(12) **EUROPEAN PATENT APPLICATION**
published in accordance with Art. 158(3) EPC

(43) Date of publication:
**12.04.2006 Bulletin 2006/15**

(51) Int Cl.:
*H01L 21/205* (1974.07)        *H01L 21/31* (1974.07)
*C23C 16/455* (2000.01)        *H05H 1/46* (1980.01)

(21) Application number: **04746368.2**

(22) Date of filing: **24.06.2004**

(86) International application number:
**PCT/JP2004/008899**

(87) International publication number:
**WO 2005/001917 (06.01.2005 Gazette 2005/01)**

(84) Designated Contracting States:
**DE FR**

(30) Priority: 25.06.2003 JP 2003181395
09.10.2003 JP 2003351283
09.10.2003 JP 2003351284
22.04.2004 JP 2004127312
22.04.2004 JP 2004127313
24.06.2004 JP 2004186435

(71) Applicant: **SEKISUI CHEMICAL CO., LTD.**
**Osaka-shi,**
**Osaka 530-8565 (JP)**

(72) Inventors:
• **ANZAI, Junichiro**
**c/o Sekisui Chemical Co., Ltd.**
**Hachioji-city, Tokyo 1920906 (JP)**
• **NAKANO, Yoshinori**
**c/o Sekisui Chemical Co., Ltd.**
**Hachioji-city, Tokyo 1920906 (JP)**

• **KAWASAKI, Shinichi**
**c/o Sekisui Chemical Co., Ltd.**
**Hachioji-city, Tokyo 1920906 (JP)**
• **NAKATAKE, Sumio**
**c/o Sekisui Chemical Co., Ltd.**
**Hachioji-city, Tokyo 1920906 (JP)**
• **MAYUMI, Satoshi**
**c/o Sekisui Chemical Co., Ltd.**
**Hachioji-city, Tokyo 1920906 (JP)**
• **MIYAMOTO, Eiji**
**c/o Sekisui Chemical Co., Ltd.**
**Hachioji-city, Tokyo 1920906 (JP)**
• **TAKEUCHI, Toshimasa**
**c/o Sekisui Chemical Co., Ltd.**
**Hachioji-city, Tokyo 1920906 (JP)**

(74) Representative: **Wagner, Bernhard Peter**
**ter Meer Steinmeister & Partner GbR**
**Mauerkircherstrasse 45**
**81679 München (DE)**

(54) **DEVICE AND METHOD FOR SURFACE TREATMENT SUCH AS PLASMA TREATMENT**

(57)     PROBLEM TO BE SOLVED

In a surface processing apparatus for spraying a processing gas onto the surface of an object to be processed through a hole-row such as a slit, the surface of the object having a large area can effectively be processed even if the hole-row is short.

MEANS FOR SOLVING

A plurality of electrode plates 11, 12 are arranged, in side-by-side relation, on a processor 1 of a plasma surface processing apparatus M. A slit-like hole-row 10a is formed between the adjacent electrode plates, and a hole-row group 100 is constituted by the side-by-side arranged hole-rows 10a. The object W is moved along the extending direction of each slit 10a by a moving mechanism 4.

FIG. 1

**Description**

TECHNICAL FIELD

This invention relates to an apparatus and a method for conducting a surface processing such as film deposition, etching, etc., by spraying a processing gas onto an object to be processed, such as plasma CVD, thermal CVD and the like. Particularly, it relates to a so-called remote type plasma processing apparatus and a method in which an object to be processed is arranged outside the space formed between adjacent electrodes and a plasma formed between the electrodes is sprayed onto the object.

BACKGROUND ART

In Patent Document 1, for example, there is described a remote type plasma processing apparatus as a surface processing apparatus. This apparatus includes a plasma processor composed of a plurality of vertical electrode plates arranged in a side-by-side-relation. Of those electrode plates, every other electrode plates are connected to a high frequency power source and the remaining every other electrode plates are grounded. A slit is formed between every adjacent two of the electrode plates. A processing gas is introduced into this slit from above. In parallel, a high frequency electric field is applied into the slit between the adjacent electrode plates by the supply of high frequency electric power to the first-mentioned every other electrode plates from the power source. Owing to this arrangement, the processing gas is plasmatized and the slit between the adjacent electrode plates is turned out to be a plasmatizing space. The plasmatized gas is jetted out from a lower end of the slit and applied to an object to be processed which is arranged beneath. By doing so, a plasma surface processing is conducted with respect to the object.
In Patent Document 2, there is described a technique in which a plasma is sprayed to an object to be processed while moving the object in a direction orthogonal to the extending direction of electrode plates and thus, the extending direction of a slit formed between adjacent two of the electrode plates. By arranging such that the electrode plate and thus the slit are made to have a length extending over the entire width of the object, the entire object can be processed at a time.
In an apparatus described in Patent Document 3, a plurality of gas jet means including an electrode plate pair are arranged in a side-by-side relation. An object to be processed is relatively moved along the extending direction of a slit formed between adjacent electrode plates.

[Patent Document 1] Japanese Patent Application Laid-Open No. H05-226258 (page 1)
[Patent Document 2] Japanese Patent Application Laid-Open No. 2002-143795 (page 1)
[Patent Document 3] Japanese Patent Application Laid-Open No. 2003-249492 (page 1)

DISCLOSURE OF THE INVENTION

PROBLEM TO BE SOLVED BY THE INVENTION

The apparatus described in the Patent Document 1 is unable to cope with an object having a vast area because the number of the electrode plates is too limited. In contrast, with respect to an object having a small area, the number of electrode plates becomes more than necessary and excessive electric power and processing gas are wastefully consumed
Moreover, in the Patent Documents 1 and 2, the larger the area of the object becomes, the longer the slit and thus, the electrode plate must be dimensioned. If the slit and the electrode plate are dimensioned longer, the electrode plate is readily bent by its own gravity, Coulomb force, thermal stress, etc. It is also not easy to obtain the dimensional accuracy of the slit and the electrode plate. Moreover, the processing unit is exponentially increased in weight in accordance with increase in number of the electrode plates.
In the apparatus of Patent Document 3, the pairs of electrode plates and thus, the slit formed between every adjacent two of the electrode plates are not arranged at equal pitches and the processing intervals are not constant. Moreover, there is no explicit description on the relation between the electrode plate pitch between the adjacent gas jet means and the electrode plate pitch within the respective gas jet means.
It is, therefore, a primary object of the present invention to provide a technique capable of, in a surface processing such as film deposition, etching, etc., plasma CVD, thermal CVD and the like, conducting the surface processing of an object having a large area efficiently and further capable of making the processing intervals constant even if the respective slits (slit-rows) for jetting processing gas is designed short and small.

MEANS FOR SOLVING THE PROBLEM

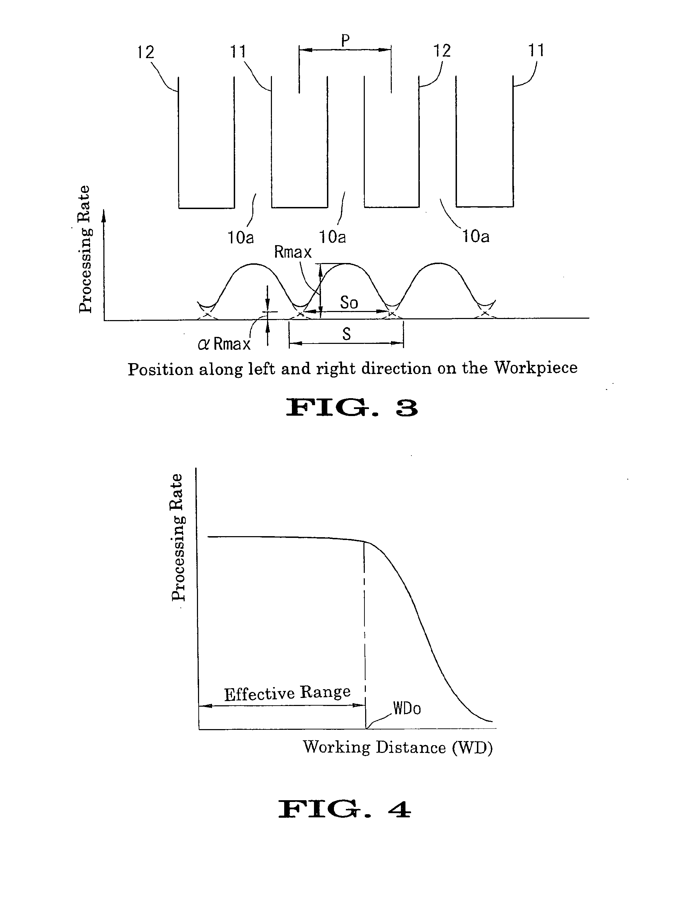

In an apparatus for processing the surface of an object to be processed (workpiece) by spraying a processing gas onto the object, a surface processing apparatus according to the present invention comprises a processor having a group of hole-rows composed of hole-rows each extending in one direction and arranged each other in a side-by-side relation; at equal pitches in a direction intersecting with the extending direction of each of the hole-rows, the processing gas being blown through each of said hole-rows, and a moving mechanism for relatively moving the processor in a direction intersecting with the side-by-side arranging direction with respect to the object.
Owing to this arrangement, each hole-row can be made short. On the other hand, even if the object has a large area, the surface can be processed efficiently and the processing intervals can be made constant.
In the above-mentioned arrangement, the hole-row may be composed of a single slit (elongate gap) or may be composed of a plurality of small holes or short slits arranged in a row.
The relatively moving direction may be along the extending direction of each hole-row. In that case, the extending direction of each hole-row (i.e., the relatively moving direction) and the side-by-side arranging direction are desirably orthogonal to each other but they may be slantwise intersected with each other. The pitch is desirably set to be generally equal to an effective processing width when a distance between the hole-rows and the object, i.e., working distance is set to a neighborhood of the upper limit of an effective range (allowable range). Owing to this arrangement, the regions processed by the plasmas coming from the respective hole-rows can be made continuous in the side-by-side arranging direction. The effective range of the distance between the hole-rows and the object refers to a range where a processing rate at a certain point on the object can be held in an effective definite valve or more (see FIG. 4). Similarly, the effective processing width refers to an effective range of width dimension within the whole range where the surface processing is conducted by plasma jetted through a single hole-row, and the processing effective range refers to a range where a processing rate corresponding to the single hole-row becomes a predetermined ratio (for example, 15% to 25%) or more of the maximum value.
Each of the hole-rows may be slantwise extended with respect to the relatively moving direction. Owing to this arrangement, uniformity of the surface processing can be enhanced.
In this slantwise extending construction, it is also accepted that each of the hole-rows is slantwise extended with respect to the relatively moving direction and the hole-rows are arranged each other in side-by-side relation in a direction orthogonal to the relatively moving direction.
In the alternative, it is also accepted that each of the hole-rows is slantwise extended with respect to the relatively moving direction and the hole-rows are arranged each other in side-by-side relation in a direction orthogonal to this extending direction. In this slantwise extending construction, the pitch may also be set to be approximately equal to the effective processing width when the distance between the hole-rows and the object is in the neighborhood of the upper limit of the effective range.
In the above-mentioned slantwise extending construction, it is desirous that one end part in the extending direction of one of two hole-rows disposed adjacent or every predetermined hole-row(s) of all the hole-rows is located on a same linear line along the relatively moving direction as the other end part in the extending direction of the other of the two hole-rows. Owing to this arrangement, uniformity of the surface processing can be further enhanced.
The apparatus may further comprise a swing mechanism for relatively swinging the processor in a direction intersecting with the relatively moving direction with respect to the object. Owing to this arrangement, the surface processing can be more uniformized. It is desirous that the swinging direction is along the side-by-side arranging direction or along the direction orthogonal to the extending direction.
The processor may include a plurality of stages of the hole-row groups in the extending direction. Owing to this arrangement, the surface processing can be conducted sufficiently.
The hole-rows of adjacent hole-row groups are desirably deviated in the side-by-side arranging direction. Owing to this arrangement, the surface processing can be uniformized. Especially, in case the extending direction of the hole-row and the relatively moving direction are in parallel relation, striped non-uniformity can effectively be prevented from occurring.
The amount of deviation is desirously 1/n (n is the number of the stages of the hole-row group) of the pitch. Owing to this arrangement, uniformity of the surface processing can be further enhanced.
In the above-mentioned multi-stage construction, it is accepted that the apparatus further comprises a first swing mechanism which relatively swings a hole-row group of one of two adjacent stages of the plurality stages in a direction intersecting with the relatively moving direction with respect to the object and a second swing mechanism which relatively swings a hole-row group of the other of the two stages in the same direction as the relatively swinging direction of the first swing mechanism with the phase shifted from that of the first swing mechanism. Owing to this arrangement, uniformity of the surface processing can further be enhanced.
The surface processing apparatus is a device for jetting a processing gas from the hole-row group so as to be applied to the object and includes, in addition to a plasma processing apparatus, a thermal CVD apparatus.
In case of the plasma processing apparatus, it is desirous that the processor includes a plurality of electrode members arranged in a side-by-side relation at equal pitches, a slit-like gap as one of the hole-rows is formed between two adjacent electrode members of said plurality of electrode members, and the hole-row group (group of slit-like hole-rows, i.e., slit group) is constituted by the gap formed between the adjacent electrode members, a processing gas for plasma processing the object being passed through the gap. When the present invention having such a construction as just mentioned is applied to a plasma processing apparatus, the electrode member can be made small in size and light in weight, and the apparatus can be prevented from being bent by increasing the mechanical strength. Moreover, dimension accuracy can easily be obtained. In addition, the apparatus can cope with an object having a large area by increasing the number of the electrode members arranged in side-by-side relation, and there is no need of increasing the size of the individual electrode members. The electrode members each have, for example, a plate-like configuration.

The adjacent electrodes are given with, for example, mutually opposite polarities, and each gas serves as a plasmatizing space, and a processing gas passed through the plasmatizing space is plasmatized and jetted. In the plasma CVD, etc., it is also accepted that a specific electrode member has a same polarity as that of an electrode member adjacent to one side of the specific electrode member and the specific electrode member has an opposite polarity to that of an electrode member adjacent to the other side, a reactive gas as the processing gas, which is excited by plasma, is passed between the adjacent electrode members having the opposite polarity, and a film material gas as the processing gas is passed between the adjacent electrode members having the same polarity.

In the above-mentioned plasma processing apparatus, it is also accepted that the processor includes a plurality of electrode modules separatably connected in the side-by-side arranging direction of said hole-rows, each of the electrode modules includes a plurality of electrode members arranged in a side-by-side relation at equal pitches and constitutes a part of the hole-row group (slit group). Owing to this arrangement, the size of the entire hole-row group can be made to flexibly cope with the size of the object by adjusting the connecting number of the electrode modules.

It is desirous that the adjacent two electrode modules each have an end electrode member arranged at mutually opposing ends, the end electrode member of one of the two electrode modules is put together with the end electrode member of the other of the two electrode modules so that these end electrode members constitute a single combined electrode member, the combined electrode member being equal in thickness to the other respective electrode members of the adjacent two electrode modules. Owing to this arrangement, the pitch of the slit-like hole-rows can be made equal to the rest part even at the connecting part between the two electrode modules.

It is desirous that the processor includes a flow rectification path for uniformizing processing gas, and the hole-rows are continuous with the flow rectification path such that the hole-rows are branched. In the plasma processing apparatus, it is also desirous that the processor includes a plurality of module units separatably connected in the side-by-side arranging direction, each of the module units comprises the electrode module and a flow rectification module connected to the electrode module, the flow rectification module includes a flow rectification path for uniformizing processing gas, and hole-rows of the electrode module are connected to the flow rectification path such that the hole-rows are blanched in each of the module unit. Owing to this arrangement, a processing gas uniformized in a single flow rectification path can be passed through a plurality of hole-rows and processing corresponding to those hole-rows can be conducted more uniformly.

According to another feature of the present invention, there is provided an apparatus for plasma processing an object to be processed by jetting a processing gas through a plasmatizing space and applying the processing gas onto an object arranged outside the plasmatizing space, wherein the apparatus comprises a first electrode module and a second electrode module arranged each other in side-by-side relation in one direction, the first and second electrode modules each include a plurality of electrode members arranged in side-by-side relation in the same direction as the side-by-side arranging direction of the first and second electrode modules, and a support part for connecting and supporting the electrode members, a gap serving as the plasmatizing space is formed between every adjacent electrode members, a first end electrode member of all the electrode members of the first electrode module located at an end on the second electrode module side and a second end electrode member of all the electrode members of the second electrode module located at an end on the first electrode module side are combined to form a single combined electrode member, and electrode members other than the first end electrode member of the first electrode module, the combined electrode member and electrode members other than the second end electrode member of the second electrode module are arranged at equal pitches with respect to one another. According to this characteristic construction, the size of the object can flexibly be met by adjusting the number of the electrode modules arranged in side-by-side relation. Moreover, processing can be conducted at the same pitches as in the position corresponding to each electrode module even in the position corresponding to the connecting part between the electrode modules, and uniformity of the surface processing can be obtained. This electrode module construction can also be applied to an apparatuses having no moving mechanism, i.e., apparatus in which processing is conducted with respect to a processor including an electrode module in a positionally fixed manner.

The first end electrode member and the second end electrode member have the same polarity. Moreover, it is desirous that the first end electrode member and the second electrode member, i.e. the combined electrode member, are electrically grounded. Owing to this arrangement, an electric leakage can be prevented.

According to one preferred embodiment of the present invention, in the first electrode module, the first end electrode member integrally includes a first enlarged-thickness part protruding toward the second electrode module, and a first reduced-thickness part which is smaller in thickness than the first enlarged-thickness part and withdrawn to the opposite side of the second electrode module side, in the second electrode module, the second end electrode member integrally includes a second reduced-thickness part which is withdrawn to the opposite side of the first electrode module side and a second enlarged-thickness part which is bigger in thickness than the second enlarged-thickness part and protruding toward the first electrode module, and in the combined electrode member, the first enlarged-thickness part and the second reduced-thickness part are put together with each other and the first reduced-thickness part and the second enlarged-thickness part are put together with each other. Owing to this arrangement, the first and second end electrode members can firmly be connected, combined and easily be separated.

In this preferred embodiment, in case the temperature of the first end electrode member is to be adjusted, a temperature adjusting path for allowing a fluid for adjusting the temperature of the first end electrode member to pass therethrough is desirously formed within the first enlarged-thickness part. Owing to this arrangement, the temperature adjusting path can easily be formed.

According to another preferred embodiment of the present invention, the combined electrode member is divided into a plurality of partial electrode members along a width direction intersecting with the side-by-side arranging direction, one of the adjacent partial electrode members is supported by the support part of the first electrode module thereby constituting the first end electrode member, and the other of the adjacent partial electrode members is supported by the support part of the second electrode module thereby constituting the second end electrode member. Owing to this arrangement, the first and second end electrode members can firmly be connected and in addition, since there is no need of partially reducing the first and second end electrode members, sufficient rigidity can be obtained and bending can be restrained. Moreover, partial electrode members can easily be manufactured.

A temperature adjusting path for allowing a fluid for adjusting the temperature to pass therethrough is preferably formed within the partial electrode member. Since the partial electrode member is not required to be made thin, the temperature adjusting path can easily be formed.

It is desirous that the respective electrode members of the first and second electrode modules each have a plate-like configuration intersecting with the side-by-side arranging direction, the plate-like respective electrode members other than the first end electrode member of the first electrode module, the plate-like combined electrode member and the plate-like respective electrode members other than the second end electrode member of the second electrode module are equal in thickness. Owing to this arrangement, the pitches can easily and reliably be made equal.

A surface processing method according to the present invention comprises the step of blowing a processing gas through each of a plurality of hole-rows arranged in a side-by-side relation in a direction at equal pitches on a processor so as to be sprayed onto an object to be processed while relatively moving the processor in a direction intersecting with the side-by-side arranging direction with respect to the object. Owing to this arrangement, each hole-row can be made short. On the other hand, surface processing can efficiently be conducted with respect to an object even if the object has a large area.

The processing gas jetting may be conducted while relatively moving the object along the extending direction of each hole row or the processing gas jetting may be conducted while relatively slantwise moving the object with respect to the extending direction of each hole row.
It is desirous that the pitch is set to be approximately equal to an effective processing width when a distance between the hole-rows and the object is in a neighborhood of the upper limit of an effective range and the processing is conducted under such a condition that the distance is in a neighborhood of the upper limit of the effective range.

It is desirous that the processor is constituted by arranging a plurality of stages of hole-row groups composed of hole-rows having the equal pitches in the extending direction and the adjacent two stages of the hole-row groups are deviated in the side-by-side arranging direction, the relative movement being conducted with respect to the plurality of stages of the hole-row groups altogether. Owing to this arrangement, uniformity of the surface processing can be enhanced.

The processing gas jetting may be conducted while further relatively swinging the processor in a direction intersecting with the relatively moving direction with respect to the object. Owing to this arrangement, uniformity of the surface processing can further be enhanced.

It is also accepted that the processor is constituted by arranging a plurality of stages of hole-row groups composed of hole-rows having the equal pitches in the extending direction, in parallel with the relative movement, the hole-rows of the adjacent stages being relatively swung in a way as to be deviated in phase in a direction intersecting with the relatively moving direction with respect to the object.

A swinging width of the swinging motion is desirously small enough when compared with the relatively moving distance of the object. It is also desirous that a swinging width of the swinging motion is set to be 1/2 or slightly larger than 1/2 of the pitch. Owing to this arrangement, uniformity of the surface processing can reliably be obtained.

The cycle of the swinging motion is desirously set to be 1/m times (m: integer) of a required time for the object to relatively move by a distance corresponding to the length of the hole-row. Owing to this arrangement, uniformity of the surface processing can more reliably be obtained.

The present invention is applied to plasma processing under the circumstance of, for example, generally normal pressure (pressure in the neighborhood of atmospheric pressure). The generally normal pressure used in this invention refers to a pressure range of $1.013 \times 10^4$ to $50.663 \times 10^4$ Pa, preferably $1.333 \times 10^4$ to $10.664 \times 10^4$ Pa and more preferably $9.331 \times 10^4$ to $10.397 \times 10^4$ Pa when easiness of pressure adjustment and simplification of the construction of the apparatus are taken into consideration.

BEST MODE FOR CARRYING OUT THE INVENTION

Embodiments of the present invention will be described hereinafter with reference to drawings.

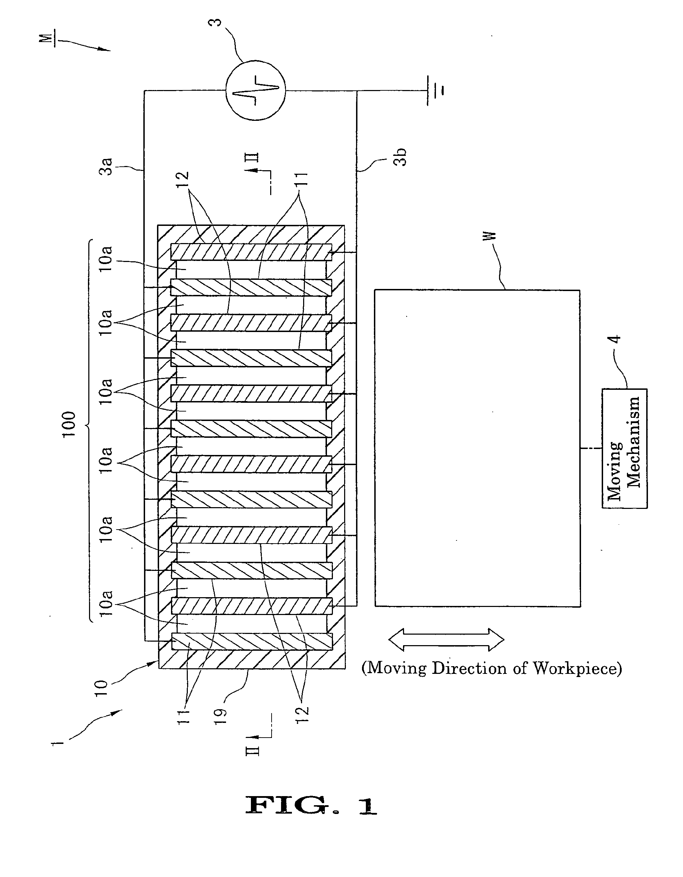

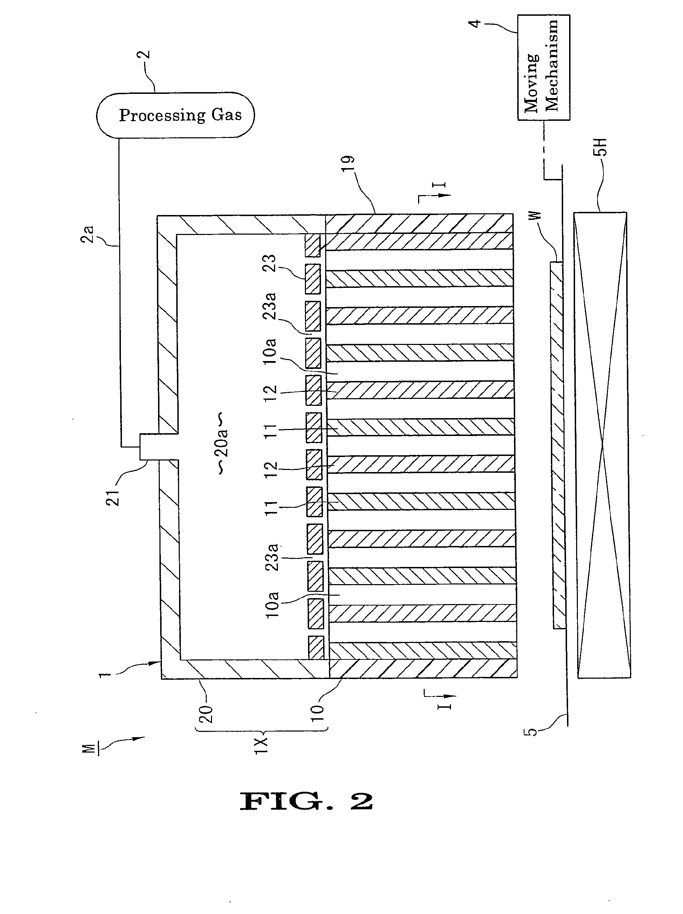

FIGS. 1 and 2 show a first embodiment according to a basic construction of the present invention. A normal pressure plasma processing apparatus M as a surface processing apparatus comprises a plasma processing head 1 (processor), a processing gas supply source 2, a power source 3 and a moving mechanism 4. This plasma processing apparatus M 1 is adapted to plasma process the surface of a workpiece W, as an object to be processed, having a large area such as a liquid crystal glass substrate and a semiconductor wafer under an approximately normal pressure (under a neighborhood of the atmospheric pressure).

The processing gas supply source 2 reserves therein a single or a plurality of processing gas components in gas or liquid phases. The gas component in a liquid phase is evaporated and in case of a plurality of components, suitable quantities of those gas components are admixed to produce a processing gas in accordance with a processing purpose.

The power source 3 is provided as an electric field applying means which outputs, for example, a pulse voltage as a voltage for forming plasma in the processing head 1. It is desirous that the pulse rising time and/or falling time is 10 μs or less, the pulse continuing time is 200 μs or less, the electric field intensity in the slit 10 between adjacent electrodes as later described is 1 to 1000 kV/cm and the wave frequency is 0.5 kHz or more.

The power source 3 is not limited to one for outputting a pulse voltage but it may be one for outputting a sinusoidal high frequency AC voltage or for outputting a DC voltage.

The moving mechanism 4 is connected with a horizontal workpiece set table 5 (only shown in FIG. 2). A workpiece W is set on this workpiece set table 5 in its horizontal attitude. The moving mechanism 4 transfers the workpiece table 5 and thus, the workpiece W in the back and forth directions (directions as indicated by a two-headed arrow of FIG. 1). By doing so, the workpiece W is passed under the processing head 1 and subjected to plasma surface processing. The workpiece W may be processed while it is reciprocally moved, or while it is moved in a forward direction or backward direction (only a single movement) and then removed from the workpiece table 5. It is, of course, accepted that the workpiece W is positionally fixed and the moving mechanism 4 is connected to the processing head 1 to move it. The moving mechanism 4 may be a roller conveyor or the like. In case of a roller conveyor, the workpiece W can be directly set onto the roller conveyor and therefore, the workpiece set table 5 can be eliminated.

As shown in FIG. 2, a workpiece temperature adjusting device 5H (object temperature adjusting means) such as a heater is attached to the workpiece set table 5 of the apparatus M. By this workpiece temperature adjusting device 5H, the workpiece W is heated or cooled to a suitable temperature for processing. The workpiece temperature adjusting device 5H may be arranged outside the workpiece set table 5.

The plasma head 1 of the plasma processing apparatus M will be described.

As shown in FIG. 2, the processing head 1 is supported on a support base, not shown, such that the processing head 1 is located in a higher position than the workpiece set table 5 and thus, the workpiece W set onto the table 5. The processing head 1 is constituted of a single module unit 1X. The module unit 1X includes an electrode module 10 and a flow rectification module 20 installed on an upper side of this electrode module 10. The electrode module 10 constitutes a plasma discharger and the flow rectification module 20 constitutes a flow rectifier.

A receiving port 21 and a flow rectification path are formed on the flow rectification module 20. A tube 2a leading from the processing gas supply source 2 is connected to the receiving port 21. The flow rectification path is constituted of a flow rectification chamber 20a, a slit-like (or spot-like) flow rectification hole 23a, etc. The gas flow rectification module 20 is provided at a lower end part thereof with a flow rectification plate 23 as a flow rectification hole forming member. A plurality of flow rectification holes 23a are formed in the flow rectification plate 23 at equal pitches on the left and right sides. Each flow rectification hole 23a is in the form of a slit extending in the back and forth directions (directions orthogonal to the paper surface of FIG. 2). Instead of a slit form, the rectification holes 23a may be a plurality of spot-like holes which are arranged on the front and back sides in a dispersing manner. Those flow rectification holes 23a are connected in one-to-one correspondence with slits 10a formed between electrode plates as later described. That is, a plurality of slits 10a are connected to a single flow rectification path such that the slits 10a are branched therefrom. It is also accepted that a plurality of flow rectification plates 23 are arranged in upper and lower relation, so that a flow rectification chamber can be partitioned into a plurality of portions. The processing gas coming from the supply source 2 is received in the receiving port 21 of the gas flow rectification module 20 via the tube 2a, then rectified/uniformized by a flow rectification path which is constituted of the chamber 20a, the flow rectification holes 23a, etc., and thereafter, introduced into the electrode module 10.

As shown in FIG. 1 and 2, the electrode module 10 of the processing head 1 includes an insulating casing 19, and an electrode-array (electrode-row) received in this casing 19. The casing 19 is open at its upper and lower sides and has a rectangular configuration, in a plan view, extending in left and right directions orthogonal to the moving direction of the workpiece W. The length of the casing 19 in the left and right directions is larger than the width dimension of the workpiece W in the left and right directions.

The electrode-array received in the casing 19 is constituted of a plurality (12 pieces in the drawings) of first and second electrode plates 11, 12 (plate-like electrode members). Those electrode plates 11, 12 are each formed of a square flat plate made of a conductive metal having the same configuration and dimension. Each electrode plates 11, 12 is arranged vertically and along the back and forth directions. Those electrode plates 11, 12 are arranged in side-by-side relation at equal pitches each other.

The front and rear end parts of the respective electrode plates 11, 12 are fixedly supported on the front and rear long walls of the casing 19.

Polarities of the electrode plates are different from each other along the side-by-side arranging direction. That is, as shown in FIG. 1, a power supply line 3a leading from the power source 3 is branched into a plurality of lines which are connected to every other electrode plates 11 of the processing head 1, respectively. Those electrode plates 11 are functioned as electric field supplying electrodes (hot electrodes), respectively. The remaining every other electrode plates 12 of the processing head 1 are grounded through an earth line 3b and functioned as ground electrodes (earth electrodes), respectively. A pulse electric field is formed between adjacent electrode plates 11, 12 by the pulse voltage coming from the power source 3.

Though not shown, a solid dielectric layer such as alumina is coated on the surfaces of the respective electrode plates 11, 12 by thermal spray.

A slit-like gap 10a is formed between adjacent electrode plates 11, 12. This gap or slit 10a is vertical and extending in the back and forth directions (moving directions of the workpiece W). A single slit 10a constitutes a "hole-row extending in one direction". The slits 10a formed between every adjacent electrodes are same in width in the left and right directions. The upper end parts of the respective electrode slits 10a are connected to the corresponding slit-like flow rectification holes 23a of the flow rectification module 20, respectively. The flow rectification holes 23a serve as introduction paths for introducing the processing gas into the electrode-to-electrode slits 10a, respectively. Each electrode-to-electrode slit 10a serves as a path for allowing the processing gas to pass therethrough and also functions as a discharge space where a glow discharge is generated by application of electric field when power is supplied to the electrode plate 11 from the power source 3. Owing to this arrangement, a plasmatizing space is provided where the processing gas is plasmatized.

The lower end parts of the respective electrode slits 10a are open so as to serve as a processing gas jet port extending in the back and forth directions.

It is also accepted that the casing 19 is separately provided at a lower end part thereof with a bottom plate serving as a jet port forming member, the bottom plate is abutted with the lower end faces of the electrode plates 11, 12, and slit-like jet ports straightly connected to the electrode-to-electrode slits 10a are formed in the bottom plate. In that case, the "single hole-row" is constituted by the electrode-to-electrode slits 10a and the slit-like jet ports connected to the slits 10a. The bottom plate is preferably composed of an insulating material such as ceramic.

In the processing head 1, a slit group 100, i.e., the "hole-row group" consisting of slit-like hole rows" is constituted by the slits 10a arranged in side-by-side relation. The slit group 100 is extended longer than the left and right width of the workpiece W.

The distance between the lower end part (jet port) of the slit 10a of the processing head 1 and the workpiece W, i.e., working distance WD (FIG. 2) is set to a value $WD_0$ in the neighborhood of the upper limit within the effective range. (The value $WD_0$ is, hereinafter, referred to as the set working distance $WD_0$.) As shown in FIG. 4, the effective range of the working distance WD refers to a range where a processing rate measured at a certain point on the workpiece W is held in an effective definite value or more. When the working distance exceeds this effective range, the processing rate at the measuring point is abruptly lowered. That is, the above-mentioned set working distance $WD_0$ is a working distance immediately before this abrupt lowering occurs. For example, $WD_0 = 6$ mm, here.

As shown in FIG. 3, the pitch between the electrode plates 11, 12 is set to be approximately equal to an effective processing width conducted by the plasmatized processing gas (hereinafter refers to as the "plasma gas", where appropriate) jetted through each slit 10a in the set working distance $WD_0$. The effective processing width refers to a width dimension of a range So where a surface processing conducted by the plasma gas jetted through a single slit 10a is effective within the whole range S where the surface processing is able to be carried out. If the processing rate conducted by the plasma gas jetted through the single slit 10a is represented by R and its maximum value is represented by $R_{max}$, the effective processing range So refers to a range where the processing rate R becomes a predetermined ratio $\alpha$ or

more with respect to the maximum value $R_{max}$. That is, it refers to a range where $R \geq \alpha \times R_{max}$ is satisfied. For example, $\alpha = 15\%$ to $25\%$. The point where R becomes $R_{max}$ is normally immediately under the center of the slit 10a. The processing range S and the effective processing range So spread leftward and rightward with respect to the point where R becomes $R_{max}$.

The width of the processing range S and thus, the effective processing range S0 depends on the working distance. When the working distance is in the effective range, i.e., in the range where $WD \leq WD_0$ is satisfied, the more increased the working distance is, the more increased the width of the effective processing range $S_0$, i.e., the effective processing width is. Accordingly, in the apparatus M of this embodiment, the effective processing width is increased as much as possible by setting the working distance S to the value $WD_0$ in the neighborhood of the upper limit, and the electrode pitch is increased as much as possible by matching the electrode pitch P to this effective processing width.

Operation of the normal pressure plasma processing apparatus M thus constructed will be described. The processing gas coming from the processing gas supply source 2 is rectified in the gas flow rectification module 20 of the processing head 1 and then uniformly introduced into the electrode-to-electrode slit 10a. In parallel with this, a pulse voltage coming from the power source 3 is applied to the alternate electrode plates 11 of the electrode module 10. By doing so, a pulse electric field is formed in each electrode-to-electrode slit 10a to generate a glow discharge and the processing gas is plasmatized (excited/activated). The plasmatized processing gas is uniformly jetted downward. Simultaneously, the workpiece W is passed under the processing head 1 in the back and forth directions, i.e., the directions parallel with the slit 10a by the moving mechanism 4. A processing gas is sprayed onto this workpiece W through each slit 10a. By doing so, the surface processing such as, film deposition, etching, cleaning and the like can be conducted.

A processing gas uniformized in a single flow rectification path can be introduced into the slits 10a, the processing gas flows within those slits 10a can be uniformized and thus, processing corresponding to those slits 10a can be conducted uniformly.

As shown in FIG. 3, owing to the above-mentioned relation between the pitch P of the slit 10a and the effective processing width, the range where the surface processing is effectively conducted by plasma gas coming from a single slit 10a and be made continuous with the range where the surface processing is effectively conducted by plasma gas coming from its next slit 10a. At positions immediately under the respective electrodes plates 11, 12, the processing rates conducted by the plasma gas jetted through the slits 10a, 10a on the both side are overlapped with each other as indicated by broken lines of FIG. 3. Accordingly, as indicated by solid lines of FIG. 3, the actual processing rate can be multiplied. Owing to this arrangement, the workpiece W can be processed uniformly in the left and right directions. Moreover, since the slit group 100 extends longer than the left and right width of the workpiece W, the entire left and right width of the workpiece W can be processed at a time. Then, by moving the workpiece W forwardly and backwardly by the moving mechanism 4, the entire surface of the workpiece W can be processed effectively.

A workpiece having a large area (laterally wide width) can be met by increasing the number of the electrode plates 11, 12 and thus, by increasing the number of the electrode-to-electrode slits 10a arranged in side-by-side relation. The dimension of the respective electrode plates 11, 12 can be made small irrespective of the size of the workpiece W. Accordingly, dimensional accuracy can easily be obtained and in addition, the weight can be reduced. Thus, the bending amount of the electrode plates 11, 12 caused by bent by its own gravity, Coulomb force, thermal stress, etc. can be reduced. Since oppositely directing Coulomb forces act on each electrode plates 11, 12 (except the electrode plates located on the both left and right end sides) from the both sides and the Coulomb forces are offset as a whole, bending can more reliably be prevented.

Moreover, since the working distance is set to be as larger as possible and the effective processing width and thus, the pitch P are set to be large, the electrode plates 11, 12 can be sufficiently increased in thickness. By virtue of this feature, the electrode plates 11, 12 can be increased in strength, and bending can more reliably be prevented.

Other embodiments of the present invention will now be described. In the embodiments to follow, the identical components as in the above-mentioned embodiment are denoted by identical reference numerals and description thereof is simplified.

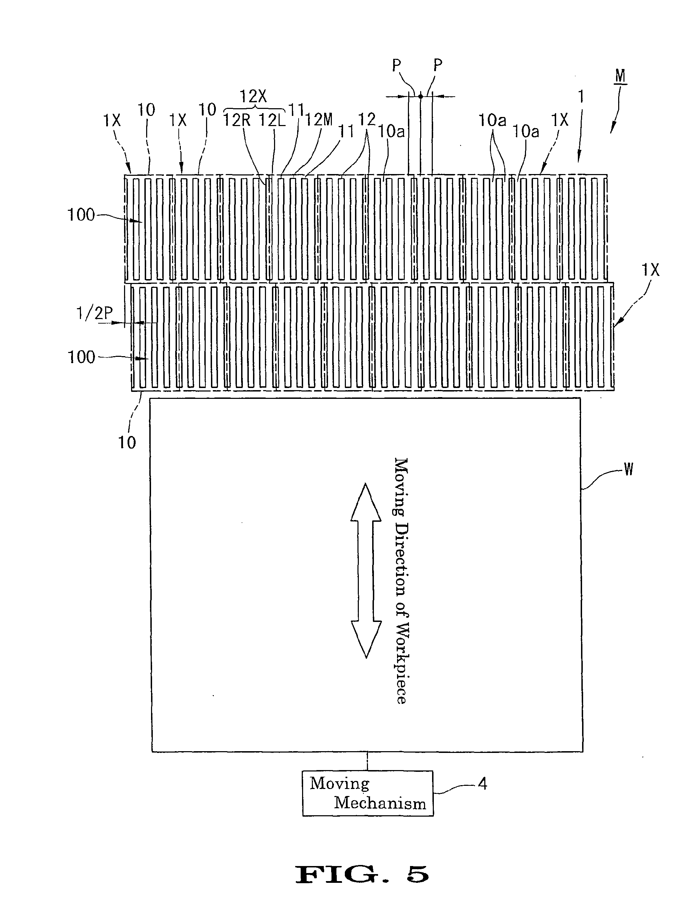

FIGS. 5 through 13 show the second embodiment of a specific construction of the present invention. The second embodiment will briefly be described with reference to FIG. 5 first.

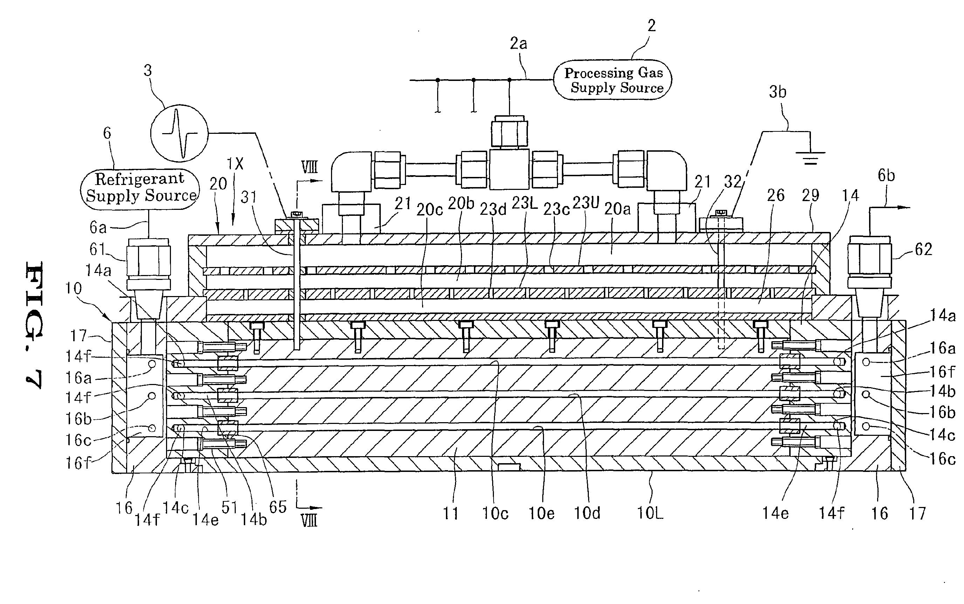

The processing head 1 of a normal pressure plasma processing apparatus according to the second embodiment comprises a large number (a plurality) of module units 1X. Those module units 1X form two stages, one on the front side (upper side in FIG. 5) and the other on the rear side (lower side in FIG. 5). A plurality of module units 1X are arranged leftward and rightward on each stage. The module units 1X, which are abutted with those located on the front and rear sides and left and right sides, are separatably connected one another. Each module unit 1X comprises, as in the first embodiment, an electrode module 10 and a flow rectification module (see FIG. 7) installed on its upper side. Accordingly, in the processing head 1, a plurality of electrode modules 1 form two stages, one on the front side and the other on the rear side and arranged leftward and rightward. The electrode modules 10, which are abutted with those located on the front and rear sides and the left and right sides, are separatably connected with one another. If one of adjacent two electrode modules 10, 10 is referred to as the "first electrode module", the other is referred to as the "second electrode module". Likewise, in the processing head 1, a plurality of flow rectification modules 20 form two stages, one on the front side and the other on the rear side and arranged leftward and rightward. A "flow rectifior" is constituted by the flow rectification modules 20 (see FIG. 7) of all module units 1X which constitute the processing head 1, and a "plasma discharger" is constituted by all electrode modules 10.

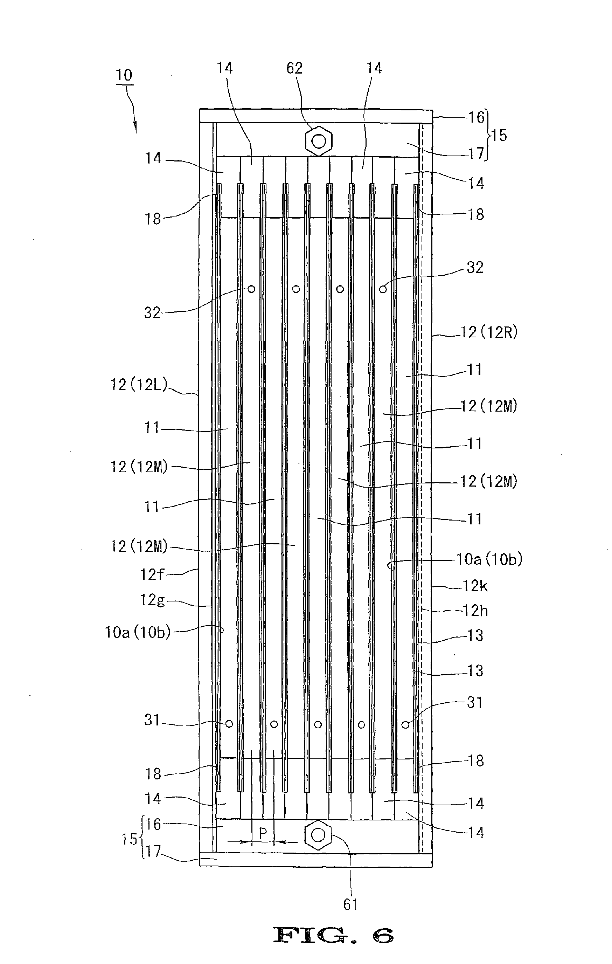

As shown in FIG. 5, each electrode module 10 is constituted by a predetermined number of electrode plates 11, 12 which are arranged leftward and rightward at constant pitches. (It should be noted that in FIG. 5, the number of electrode plates of each electrode module 10 is reduced when compared with those of the specific construction shown in FIGS. 6 through 11 just for the sake of simplification.) The electrode array on the front stage and thus, the slit group 100 on the front stage are constituted by the electrode plates 11, 12 of all electrode modules 10 on the front side stage. The electrode array on the rear stage and thus, the slit group 100 on the rear stage are constituted by the electrode plates 11, 12 of all electrode modules 10 on the rear side stage. That is, in the processing head 1, the slit groups 100 form two stages, one on the front side and the other on the rear side.

The electrode plates 12, 12 (as later described, those electrode plates are denoted by reference characters 12R, 12L, respectively) located at the opposing ends in two electrode modules 10 which are adjacent to each other in the leftward and rightward directions on each of the front and rear stages are put together with each other to constitute a single combined electrode plate 12X (combined electrode member). The combined electrode plate 12X is same in thickness as all the other electrode plates 11, 12. Owing to this arrangement, all the slit pitches of the slit groups 100 on the front and rear sides become equal each other even at the connecting part between the two electrode modules and the equal pitches P are provided all over the entire slit groups 100.

A detailed construction of the second embodiment will now be described with reference to FIGS. 6 through 13. As shown in FIG. 7, the flow rectification module 20 of each module unit 1X includes a housing 29 extending, in a long manner, in the forward and backward directions (leftward and rightward directions in FIG. 7), two (a plurality of) flow rectification plates 23U, 23L provided within the housing 29. A pair of front and rear receiving ports 21 are disposed at the upper surface of the housing 29. A supply tube 2a leading from a processing gas supply source 2 is branched for each unit 20 and connected to the receiving ports 21, respectively.

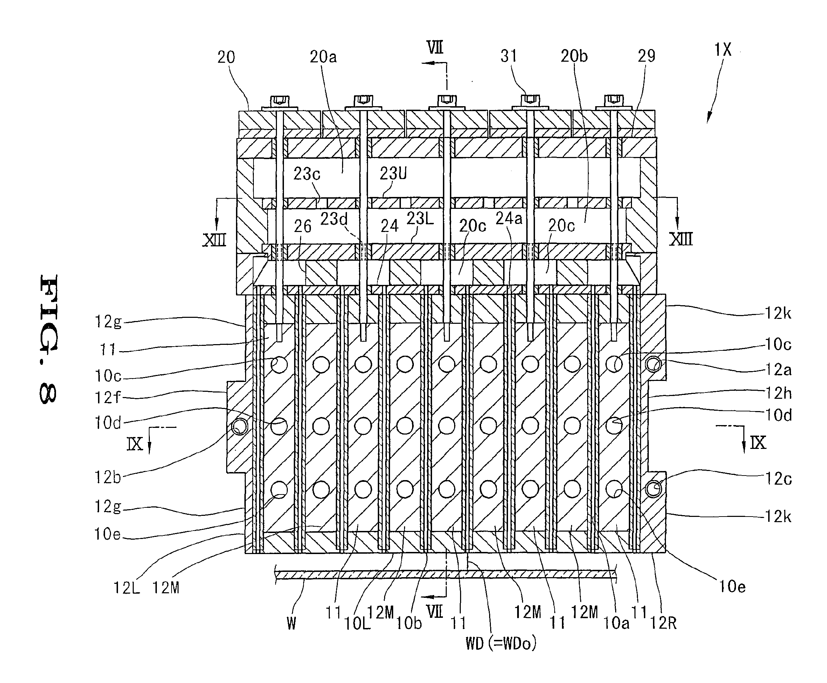

As shown in FIGS. 7 and 8, the two flow rectification plates 23U, 23L within the housing 29 are vertically spacedly arranged. The inside of the housing 29 is partitioned into three-stage (multi-stage) chambers 20a, 20b, 20c by the flow rectification plates 23U, 23L. The receiving port 21 is connected to the chamber 20a on the upper stage.

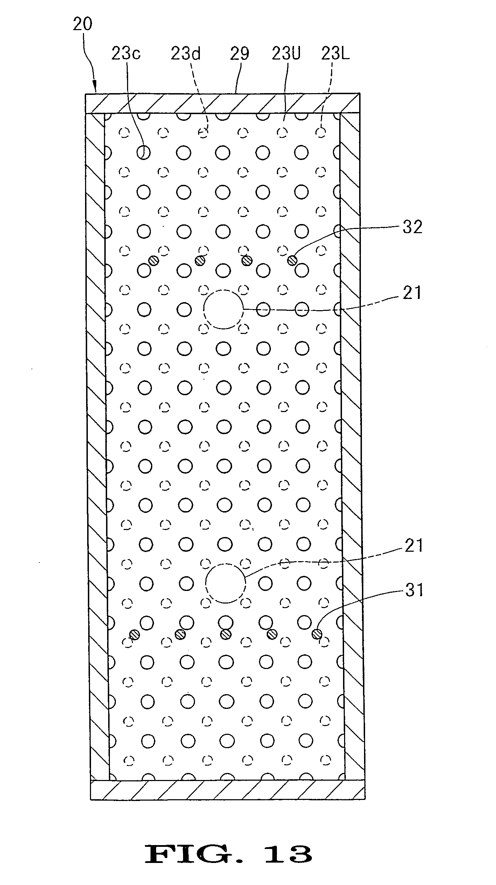

As shown in FIG. 13, the flow rectification plates 23U, 23L are each constituted of a porous plate. The upper, middle and lower chambers 20a, 20b, 20c are communicated with each other through holes 23c, 23d formed in those flow rectification plates 23U, 23L. The holes 23c, 23d of the respective flow rectification plates 23U, 23L are arranged in a row at the lattice points and at intervals of 10 mm to 12 mm, for example. It should be noted, however, that no hole is formed in a position immediately under the flow rectification plate 23U on the upper stage. Those holes 23c, 23d are sequentially reduced in size toward the flow rectification plate on the lower stage. For example, the diameter of each hole 23c of the flow rectification plate 23U on the upper stage is 3 mm, the diameter of each hole 23d of the flow rectification plate 23L on the lower stage is 2 mm. A "flow rectification path" is constituted by the chambers 20a, 20b, 20c and holes 23c, 23d of each flow rectification module 20.

As shown in FIG. 8, the housing 29 is provided at the upper surface of a bottom plate 24 thereof with four (a plurality of) support posts 26. The support posts 26 are extended forwardly and backwardly (direction orthogonal to the paper surface of FIG. 8) in a long manner and mutually separately arranged leftward and rightward. The flow rectification plate 23L on the lower stage is supported by those support posts 26. The chamber 20c on the lower stage is formed between the adjacent support posts 26. That is, the lower-stage chamber is divided into five by the support posts (partition walls) 26. Each division chamber 20c extends forwardly and backwardly in a long manner. This chamber 20c is connected to the upper end part of the electrode-to-electrode slit 10a of the electrode module 10 through a gas introduction hole 24a formed in the bottom plate 24. A single chamber 20c is in correspondence with the adjacent two slits 10a. That is, a plurality of slits 10a are connected to the flow rectification path of each flow rectification module 20 in a branching manner.

The processing gas coming from the processing gas supply source 2 is passed through the supply tube 2a and the pair of front and rear receiving ports 21 of the flow rectification module 20, and thereafter introduced into the upper-stage chamber 20. The processing gas is then flowed into the middle-stage chamber 20b through the large number of holes 23c of the flow rectification plate 23U. Since no hole 23c is formed immediately under each receiving port 21, the processing gas can fully be dispersed over the entire area within the upper-stage chamber 20a and then delivered into the middle-stage chamber 20b. Thereafter, the processing gas is flowed into the respective division chambers 20c on the lower stage through the large number of holes 23d of the flow rectification plate 23L. The processing gas is then introduced into the slits 10a between every adjacent electrodes of the electrode module 10 via the introduction holes 24a of the housing bottom plate 24.

As shown in FIG. 6, each electrode module 10 of the second embodiment includes a plurality (for example, eleven) of electrode plates 11, 12 (plate-like electrode members) arranged leftward and rightward at constant pitches, and end walls 15 (support parts) which are disposed on the front and rear ends of the electrode plates 11, 12. The electrode module 10 extends forwardly and backwardly in a long manner.

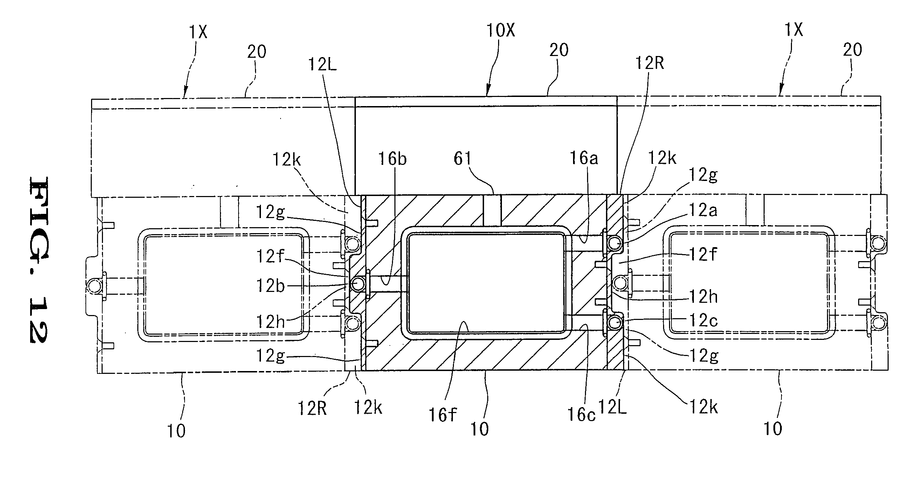

As shown in FIGS. 6 and 7, the walls 15 on the front and rear ends each include an inner wall member 16 and an outer wall member 17 bolted to the outer surface of the inner wall member 16. A large recess 16f (FIG. 12) for reserving a refrigerant, as later described, is formed in the outer surface of the inner wall member 16. The outer wall member 17 is functioned as a lid for closing this recess 16f. The outer wall member 17 is formed of metal such as stainless steel, and the inner wall member 17 is formed of resin. The reason is that an electric discharge can be prevented from occurring to the metal-made outer wall member 17 from a metal bolt 51 as later described. Resin-made filling blocks 14 for the number corresponding to the number of the electrode plates of other than the outer wall as later described are disposed at the inner surface of the inner wall member 16. The filling blocks 14 each have a vertically elongate configuration and mutually spacelessly arranged forwardly and backwardly.

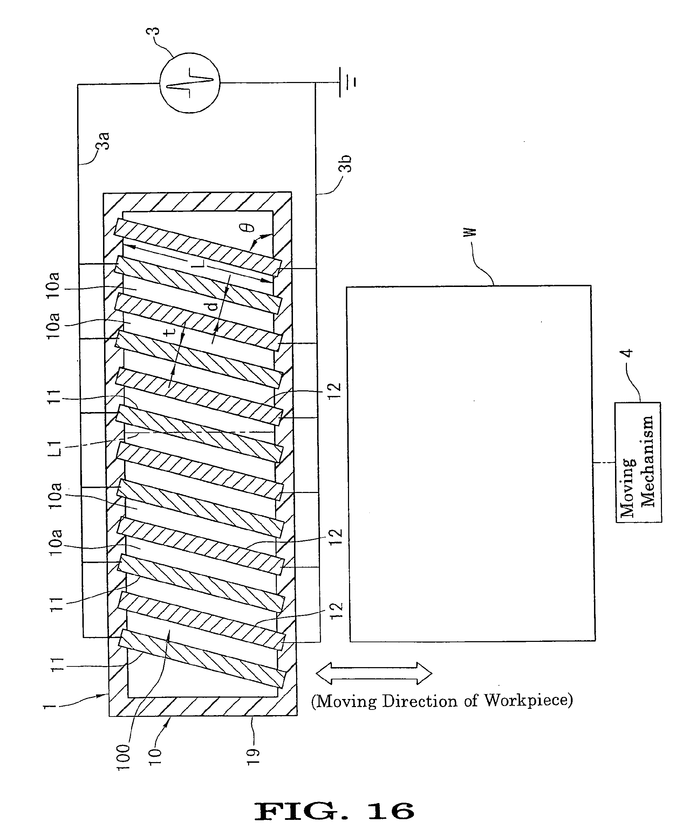

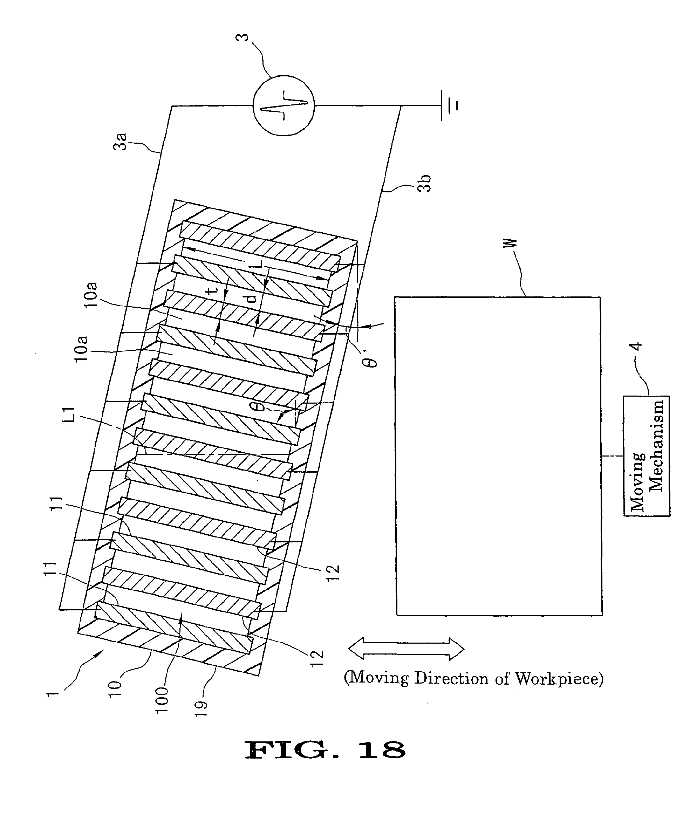

As shown in FIGS. 6 through 8, the respective electrode plates 11, 12 of the electrode module 10 are composed of conductive metal such as, for example, aluminum and stainless steel, and arranged in the posture with their long direction directing forwardly and backwardly, their thickness direction directing leftwardly and rightwardly and their width direction directing vertically. As shown in FIGS. 16 and 18, the first electrode plates 11 constituting hot electrodes and the second electrode plates 12 constituting earth electrodes are alternately arranged leftwardly and rightwardly. The second electrode plates 12, that are earth electrodes, respectively, are arranged on the left and right ends. By the left and right side electrode plates 12, the left and right outer walls of the electrode module 10 are constituted. When the left-end electrode plate 12 is to be distinguished from others, they are denoted by reference numeral 12 with "L" affixed thereto and when the right-end electrode plate 12 is to be distinguished from others, they are denoted by reference number 12 with "R" affixed thereto. When the second electrode plates 12 other than those on the left and right sides and on the front and rear sides are to be distinguished from others, they are denoted by reference numeral 12 with "M" affixed thereto.

Of the leftwardly and rightwardly adjacent two electrode modules 10, 10, if the left one is referred to as the "first electrode module" and the right one, as the "second electrode module", the right-end electrode plate 12R in the left-side electrode module 10 is the "first end electrode member" and the left-end electrode plate 12L in the right-side electrode module 10 is the "second end electrode member". On the contrary, if the right-side electrode module 10 is referred to as the "first electrode module" and the left-side electrode module, as the "second electrode module", the left-end electrode plate 12L in the right-side electrode module 10 is the "first end electrode member" and the right-end electrode plate 12R in the left-side electrode module 10 is the "second end electrode member".

The nine electrode plates 11, 12M other than those on the both ends in the electrode module 10 have flat plate-like configurations of an equal thickness. The length of those electrode plates 11, 12M in the forward and backward directions is, for example, 3000 mm, their thickness in the leftward and rightward directions is, for example, 9 mm, and their width in the upward and downward directions is, for example, 60 mm. As shown in FIG. 6, the filling blocks 14 are abutted with the front and rear end faces of the respective electrode plates 11, 12M and fixed thereto by metal bolts 51.

The electrode plates 12L, 12R on the both ends, which also serve as the outer walls of the electrode module 10, are extended longer than the inner electrode plates 11, 12M in the forward and backward directions, abutted with the filling blocks 14 on the left and right ends and the left and right end faces of the inner wall member 16, and abutted against the outer wall member 17 and bolted thereto.

As shown in FIGS. 6 through 9, solid dielectric plates 13 composed of alumina ($Al_2O_3$) or the like are applied to the both side surfaces of the electrode plates 11, 12M, respectively. Similar solid dielectric plates 13 are also applied to the flat right side surface of the left-end electrode plate 12L and the flat left-side surface of the right-end electrode plate 12R, respectively. Those solid dielectric plates 13 are, for example, 1 mm in thickness. Instead of application of the solid dielectric plates 13, film may be coated thereto by thermal spray of solid dielectric, or the like.

As shown in FIGS. 6, 8 and 9, a slit having a narrow and a predetermined thickness, i.e., electrode-to-electrode slit 10a is formed between the adjacent electrodes 11, 12 (more strictly, between their solid dielectric plates 13). As in the case with the first embodiment, the electrode-to-electrode slit 10a serves as a path for allowing the processing gas to pass therethrough and also as a discharging space where a glow discharge generates due to application of electric field which is caused by power supplied to the electrode plate 11 from the power source 3, thereby also serving as a plasmatizing space where the processing gas is plasmatized. The entirety of a single electrode module 10 has ten electrode-to-electrode slits 10a. The pitches P between those electrode-to-electrode slits 10a are equal to those between the electrode plates 11, 12.

As shown in FIGS. 6, 9 and 10, spacers 18 are each interposed between the front-side end parts and between the rear-side end parts of two solid dielectric plates 13 which are placed opposite to each other with each electrode-to-electrode slit 10a therebetween. Owing to this arrangement, the respective solid dielectric plates 13 are urged against the electrode plates 11, 12, respectively and the width in the left and right directions of the electrode-to-electrode slit 10a is kept in a predetermined value. The electrode-to-electrode slits 10a are, for example, 1 mm in thickness.

As mentioned above, the upper end part of each electrode-to-electrode slit 10a is connected to the introduction hole 24a of the flow rectification module 20 (FIG. 8).

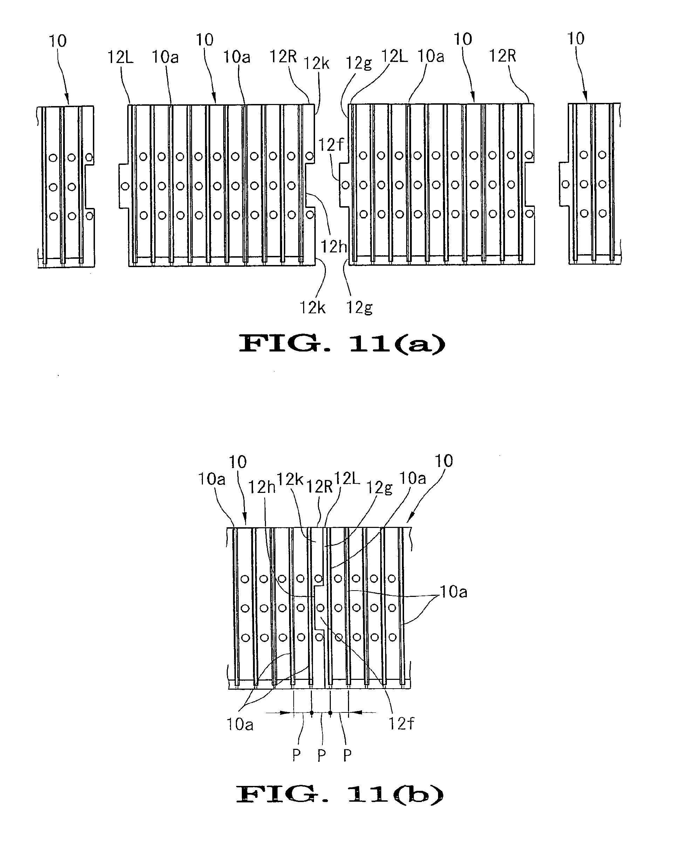

As shown in FIG. 8 and 11(a), the upper and lower parts of the left-side electrode plate 12L of each electrode module 10 are thinner in width than all the other electrode plates 11, 12M, thereby forming a pair of upper and lower reduced-thickness parts 12g, 12g. The central part in the up and down directions of the left-side electrode plate 12L has a protruding configuration which is protruded toward the adjacent electrode module 10 and forms an enlarged-thickness part 12f thicker than the reduced-thickness part 12g. As shown in FIG. 2, the reduced-thickness part 12g and enlarged thickness part 12f are extended back and forth over the entire length of the left-end electrode plate 12L. The enlarged-thickness part 12f is, for example, 7 mm in thickness and the reduced-thickness part 12g is, for example, 2 mm in thickness.

On the other hand, as shown in FIGS. 8 and 11(a), the central part in the up and down directions of the right-end electrode plate 12R of each electrode module 10 is provided with a recess formed in an outer surface thereof. Owing to this construction, the central part in the up and down direction of the right-end electrode plate 12R constitutes a reduced-thickness part 12h, and the upper and lower parts each constitute an enlarged-thickness part 12k which is thicker than the reduced-thickness part 12h. As shown in FIG. 2, the reduced-thickness part 12h and enlarged-thickness part 12k are extended back and forth over the entire length of the right-end electrode plate 12R. The reduced-thickness part 12h of the right-end electrode plate 12R is, for example, 2 mm in thickness and the enlarged-thickness part 12k is, for example, 7 mm in thickness.

If the left one of the adjacent two electrode modules 10, 10 is referred to as the "first electrode module" and the right one, as the "second electrode module", the enlarged thickness part 12k and reduced-thickness part 12h of the right-end electrode plate 12R in the left-side electrode module 10 serve as the "first enlarged-thickness part" and "first reduced-thickness part", respectively, and the reduced-thickness part 12g and enlarged-thickness part 12f of the left-end electrode plate 12L in the right-side electrode module 10 serve as the "second reduced-thickness part" and "second enlarged-thickness part", respectively. (Of course, if the right-side electrode module is referred to as the "first electrode module" and the left-side electrode module, as the "second electrode module, respectively, the enlarged-thickness part 12f and reduced-thickness part 12g of the left-side electrode plate 12L in the right-side electrode module 10 serve as the "first enlarged-thickness part" and "first reduced-thickness part", respectively, and the reduced-thickness part 12h and enlarged-thickness part 12k of the right-end electrode plate 12R in the left-side electrode module 10 serve as the "second reduced-thickness part" and "second enlarged-thickness part", respectively.)

As shown in FIGS. 11(b) and 12, in each front and rear stage of the plasma processing head 1, the enlarged-thickness part 12f having a protruded configuration of the right-side module 10 of the adjacent left and right two electrode modules 10, 10 is fitted to the reduced-thickness part 12h having a recessed configuration of the left-side module 10. Also, the enlarged-thickness part 12k having a protruded configuration of the left-side module 10 is fitted to the reduced-thickness part 12g having a recessed configuration of the right-side module 10. In this way, the right-end electrode plate 12R of the left-side module 10 is put together with the left-end electrode plate 12L of the right-side module 10. By those electrode plates 12R, 12L, a perfectly flat combined electrode plates 12X is constituted. This combined electrode plate 12X forms an earth electrode.

The thickness of the combined electrode plate 12X is same (9 mm) as those of the other electrode plates 11, 12M. Owing to this arrangement, as shown in FIG. 11(b), the electrode plate pitch is equal in size (for example, P = 12 mm) even at the connection part between the left and right adjacent two electrode modules 10 as at the rest part. That is, the electrode plates 11, 12M of the left-side module 10, the combined electrode plate 12X, and the electrode plates 11, 12M of the right-side module 10 are at the same pitch. Owing to this arrangement, the pitch of the slits 10a is uniformized to a specific size P over the entire slit group 100.

As shown in FIG. 8, the electrode module 10 is provided at a lower end part thereof with a bottom plate 10L. The bottom plate 10L is composed of an insulating material such as ceramic and applied to the lower surfaces of the electrode plate 11, 12L. A plurality of jet slits 10b are formed in the bottom plate 10L. Those jet slits 10b are extended back and forth and arranged leftward and rightward at equal pitches P in parallel. As in the case with the above-mentioned electrode-to-electrode slits 10a, the pitch of the jet slits 10b is same even at the connection part between the two electrode modules 10 adjacent in the left and right directions as at the rest part.

A step is formed on a lower side part of each jet slit 10b and each jet slit 10b is increased in width upward therefrom. The lower end parts of the two solid dielectric plates 13, 13 which are opposite to each other with the electrode-to-electrode slit 10a sandwiched therebetween are inserted in this wide part of the jet slit 10b. The electrode-to-electrode slit 10a between the two solid dielectric plates 13, 13 is connected to a lower side part from the step of the jet slit 10b. The lower end part of the jet slit 10b is open to a lower surface of the bottom plate 10L and serves as a jet port for the processing gas. A " hole-row" is constituted by a single electrode-to-electrode slit 10a and the lower end part of the jet slit 10b connected thereto.

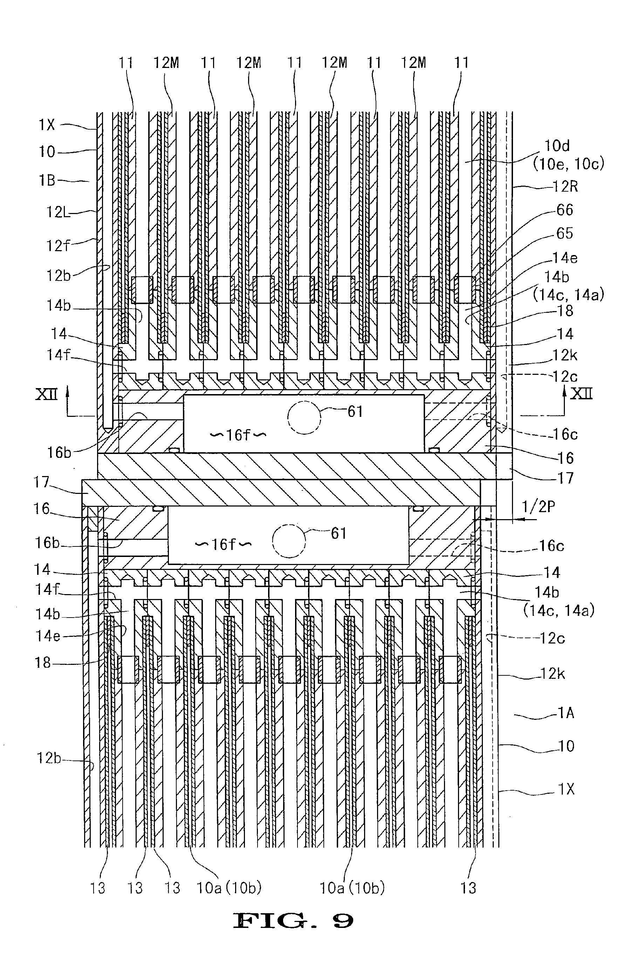

As shown in FIGS. 5 and 9, the front-stage module unit 1X and rear-stage module unit 1X of the second embodiment are deviated leftward and rightward by a portion equal to a half of the pitch P. Thus, the front-stage electrode module 10 and rear-stage electrode module 10 are deviated leftward and rightward by a portion equal to a half pitch (P/2). Owing to this arrangement, the front-stage slit group 100 and rear-stage slit group 100 are deviated leftward and rightward by a portion equal to a half pitch (P/2).

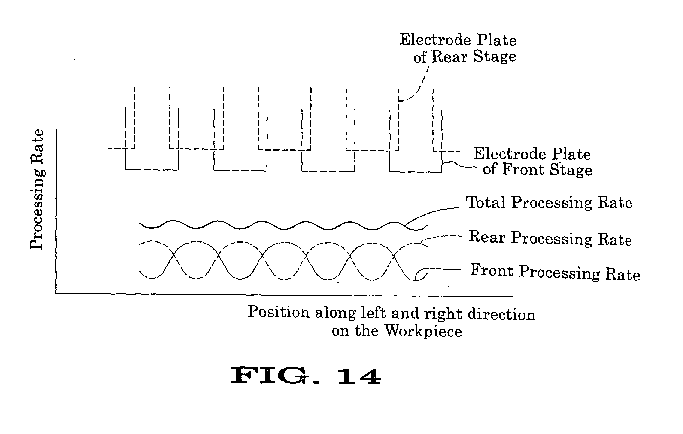

Owing to this half-pitch deviation, as indicated by the two-dot chain line of FIG. 14, the valley parts caused by the processing gas coming through the front-stage slit group 10 can be overlapped with the hump parts caused by the processing gas coming through the rear-stage slit group 100 and the front-side hump parts can be overlapped with the rear-side valley parts as indicated by the broken line of FIG. 14. As a result, as indicated by the solid line of FIG. 14, the processing rate can be uniformized in the left and right directions and the processing irregularities can be restrained. Moreover, since the slit group 100 is at the specific rate P even at the connection part between the left and right electrode modules 10, 10, uniformity of the processing can be more enhanced.

The power supply structure of the electrode plates 11, 11 in the module unit 1X of the second embodiment will be described.

As shown in FIGS. 7 and 8, five (a plurality of) power supply pins 31 are arranged leftward and rightward, in side-by-side relation, at a front part of the flow rectification module 20 such that the pins 31 are vertically passed through the front part. The upper end part of each power supply pin 31 is connected to the power source 3 through a hot line (power supply line) 3a and the lower end part is embedded in the first electrode plate 11 on the electric field supply side. Similarly, the flow rectification module 20 is provided at a rear part thereof with a ground pin 32. The upper part of the ground pin 32 is grounded through an earth line (ground line) 3b and the lower part is embedded in the second electrode plate 12 on the ground side.

The electrode module 10 of the second embodiment is provided with a cooler (temperature adjuster) for the electrode plates 11, 12.

Specifically, as shown in FIGS. 7 and 8, three (a plurality of) refrigerant paths 10c, 10d, 10e as a temperature adjusting path are formed within each electrode plate 11, 12M such that they are spaced apart upwardly and downwardly. The respective refrigerant paths 10c through 10e are extended back and forth over the entire length of the electrode plates 11, 12M.

As shown in FIG. 7, three paths 14a, 14b, 14c are formed in each of the filling blocks 14 applied to the front and rear end faces of the electrode plates 11, 12M such that they are spaced apart upwardly and downwardly. As shown in FIG. 9, the respective paths 14a through 14c each include a path part 14e extending back and forth and a path part 14f intersecting with the path part 14e leftward and rightward, and the paths 14a through 14c each have a T-shaped configuration in a plan view. The path part 14e of the upper-stage path 14a is connected to the upper-stage refrigerant path 10c of the corresponding electrode plate 11, 12M, the path part 14e of the middle-stage path 14b is connected to the middle-stage refrigerant path 10d and the path part 14e of the lower-stage path 14c is connected to the lower-stage refrigerant path 10e.

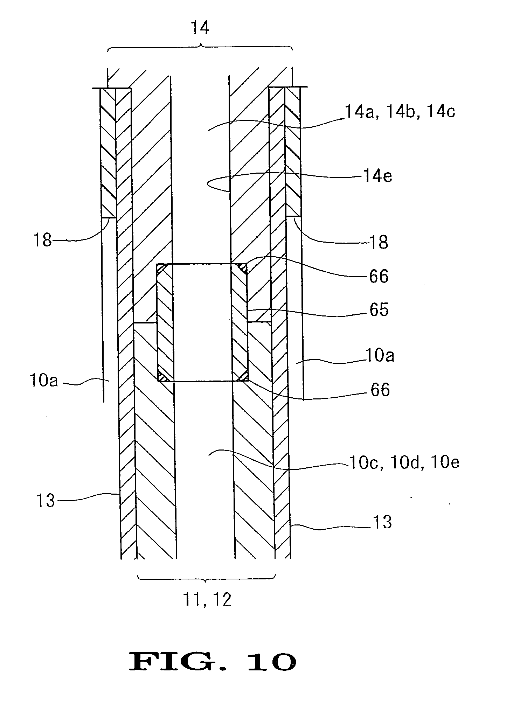

As shown in FIG. 10, a connector bush 65 having a circular cylindrical configuration is provided at the connecting part between the refrigerant paths 10c through 10e of the electrode plates 11, 12M and the path 14e of the filling block 14. The corners formed between the outer peripheral surface and the front and rear end faces of the connector bush 65 are chamfered and provided with O-rings 66, respectively. Those O-ring 66 are press collapsed by crewing bolts 51.

As shown in FIG. 9, the path parts 14f in the left and right directions of the paths 14a through 14c at the same height in the filling blocks 14 which are arranged leftward and rightward in side-by-side relation are mutually linearly connected leftward and rightward.

As shown in FIGS. 8 and 9, a refrigerant path 12b is formed in the enlarged-thickness part 12f of the left-end electrode plate 12L of each electrode module 10. The refrigerant path 12b is extended back and forth over the generally entire length of the left-end electrode plate 12L. The left and right path parts 14f of the middle-stage path 14b of the left-end filling block 14 are connected to the neighborhood parts of the front and rear ends of the refrigerant path 12b.

As shown in FIGS. 9 and 12, in each electrode module 10, the front and rear end parts of the refrigerant path 12b are connected to refrigerant reservoirs 16f through the paths 16b on the left-side parts of the front and rear inner wall members 16, respectively.

Similarly, a refrigerant path 12a is formed in the enlarged-thickness part 12k on the upper side of the right-end electrode plate 12R, and a refrigerant path 12c is formed in the enlarged-thickness part 12k on the lower side. Those refrigerant paths 12a, 12c are extended back and forth over the generally entire length of the right-end electrode plate 12R. The left and right path parts 14f (FIG. 7) of the upper-stage path 14a of the right-end filling block 14 are connected to the neighborhoods of the front and rear ends of the upper-stage refrigerant path 12a, and the left and right path parts 14f of the lower-stage path 14c are connected to the neighborhoods of the front and rear ends of the lower-stage refrigerant path 12c. The front and rear end parts of the respective refrigerant paths 12a, 12c are connected to the refrigerant reservoirs 16f through the paths 16a, 16c on the right-side parts of the front and rear inner wall members 16, respectively.

As shown in FIG. 7, the electrode module 10 is provided at an upper surface of the front-side inner wall member 16 with a refrigerant inlet port 61 connected to the refrigerant reservoir 16f. A refrigerant supply tube 6a extending from the refrigerant supply source 6 is connected to a refrigerant inlet port 61.

On the other hand, the electrode module 10 is provided at an upper surface of the rear-side inner wall member 16 with a refrigerant outlet port 62 connected to the refrigerant reservoir 16f. A refrigerant discharge tube 6b is extended from this port 62.

A refrigerant such as a cool water coming from the supply source 6 via the tube 6a is temporarily reserves in the refrigerant reservoir 16f of the front-side inner wall member 16 from the inlet port 61 and thereafter, branched into three paths 16a through 16c. The refrigerant passing through the upper-stage path 16a on the right side is flown into the upper-stage electrode plate 12R, a part of the refrigerant is flown directly backward while the remaining part of the refrigerant is flown into the upper-stage path 14a of the front-side block and thereafter branched into the upper-stage refrigerant paths 10c of the respective electrode plates 11, 12M and flown backward. The refrigerant passing through the middle-stage path 16b on the left side is flown into the refrigerant path 12b of the left-end electrode plate 12L, a part of the refrigerant is flown directly backward while the remaining part of the refrigerant is flown into the middle-stage path 14b of the front-side block and thereafter branched into the middle-stage paths 10d of the respective electrode plates 11, 12M and flown backward. The refrigerant passing through the lower-stage path 16c on the right side is flown into the lower stage refrigerant path 12c of the right-end electrode plate 12R, a part of the refrigerant is flown directly backward while the remaining part of the refrigerant is flown into the lower-stage path 14c of the front-side block and thereafter branched into the lower-stage refrigerant paths 10e of the respective electrode plates 11, 12M and flown backward. Owing to this arrangement, the electrode plates 11, 12 can entirely be cooled (temperature adjustment).

The refrigerant reached to the rear end parts of the refrigerant paths 10c through 10e of the respective electrode plates 11, 12M are passed through the rear side block paths 14a through 14c, and then converged to the rear end parts of the refrigerant paths 12a through 12c of the electrode plates 12L, 12R. Then, the refrigerant is passed through the rear side inner wall paths 16a through 16c, and then reserved in the rear-side refrigerant reservoir 161. Thereafter, the refrigerant discharged from the outlet port 62 via the tube 6b.

In case a workpiece W having a large width in the left and right directions is to be processed, the module unit 1X and thus, the electrode module 10 may be additionally jointed. Owing to this arrangement, the number of the side-by-side arrangements of the electrode plates 11, 12 and the electrode-to-electrode slits 10a can easily be increased and thus, the slit group 100 can easily be elongated. In case a workpiece W having a small width in the left and right directions is to be processed, the module units 1X and thus, the electrode modules 10 are partly withdrawn. Owing to this arrangement, the number of side-by-side arrangements of the electrode plates 11, 12 and the electrode-to-electrode slits 10a can easily be reduced and thus, the slit group 100 can easily be shortened. Owing to this arrangement, the size of the workpiece W can flexibly be met.

In the two electrode modules 10, 10 adjacent in the left and right directions, the opposing end-electrode plates 12R, 12L of the electrode modules 10, 10 can firmly be connected and combined by fitting the enlarged-thickness part 12f (12k) having a protruded configuration to the other reduced-thickness part 12h (12g) having a recessed configuration. The separating operation can also be done easily.

Since the end-electrode plate 12L, 12R have the enlarged-thickness parts 12f, 12k, respectively, the refrigerant paths 12a through 12c can be formed in those enlarged-thickness parts 12f, 12k, respectively and thus, the refrigerant paths can easily be obtained.

The electrode plates 11, 12 can be made as thick as possible by setting the working distance and the effective processing width as large as possible and thus, making the pitch P as large as possible. Owing to this arrangement, the refrigerant paths 10a through 10c can easily be formed.

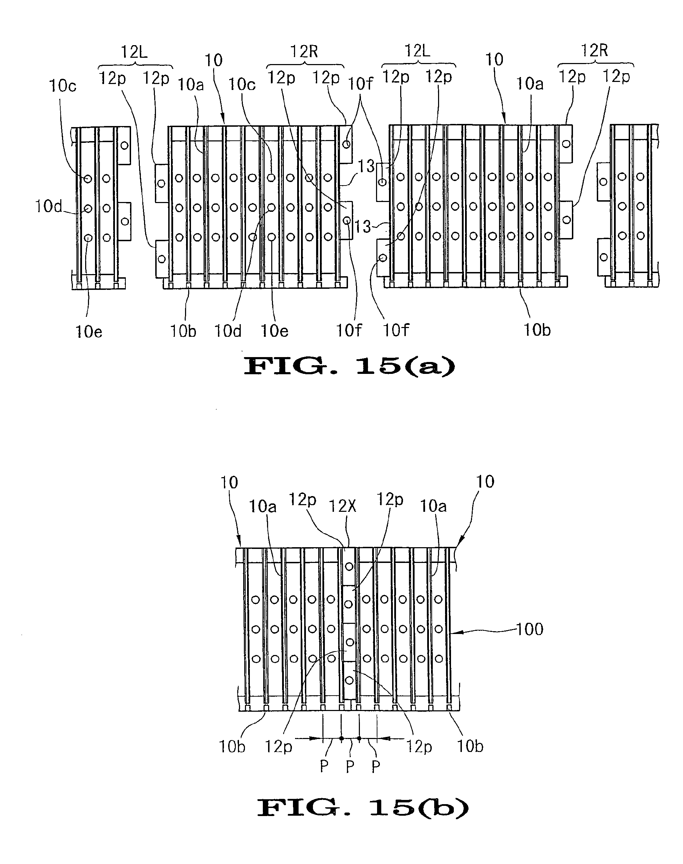

FIG. 15 shows a modified embodiment of the second embodiment.

As shown in FIG. 15(b), in this modified embodiment, a combined electrode plate 12X formed by two electrode modules 10 adjacent in the left and right directions is divided into four partial electrode plates 12p (that is, a plurality of plate-like partial electrode members) in the up and down directions. Each partial electrode plate 12p has the same thickness in the left and right directions as the other electrode plates 11, 12M and has a prismatic configuration extending in the back and forth directions intersecting with the paper surface of FIG. 15. As shown in FIG. 15(a), of those partial electrode plates 12p, the first and the third ones from top are attached to the right end part of the left-side electrode module 10 thereby constituting the right-end electrode plate 12R of the left-side electrode module 10, and the second and fourth ones are attached to the left-end part of the right-side electrode module 10 thereby constituting the left-end electrode plate 12L of the right-side electrode module 10. Though not shown in detail, the longitudinal two ends of each partial electrode plate 12p are connected to the end walls (see FIG. 6) of the corresponding electrode modules 10 and supported by them.

The first stage and third stage partial electrode plates 12p, 12p attached to the left-side electrode module 10 and the second stage and fourth stage partial electrode plates 12p, 12p attached to the right-side electrode module 10 are engaged with each other, thereby constituting a single combined electrode plate 12X.

According to the modified embodiment of FIG. 15, there is no need of forming the recessed part nor the protruded part on the end-electrode plates 12L, 12R, manufacture can be done very easily and plane accuracy can also be obtained easily. Owing to those features, the end-electrode plates 12L, 12R can reliably be surface contacted with the solid dielectric plate 13. Moreover, the partial electrode plates 12p constituting the end-electrode plates 12L, 12R are same in thickness as the other electrode plates 11, 12M and thicker than the enlarged-thickness parts 12f, 12k of the second embodiment, and they have no reduced-thickness parts 12g, 12h. Accordingly, sufficient rigidity can be obtained and bending can be restrained. Owing to those features, it can reliably be prevented that gaps are formed between the respective end-electrode plates 12L, 12R and the solid dielectric plates 13 applied thereto. As a result, a stable plasma can be obtained. Moreover, the slit group 100 can reliably be held at a specific pitch even at the connection part between the left and right electrode modules 10, and uniformity of the surface processing can be more enhanced.

Moreover, the partial electrode plates 12p constituting the end-electrode plates 12L, 12R can easily be manufactured, the number of processing steps can be reduced and the same configuration can be applied to each and every partial electrode plate 12p. Owing to those features, the member cost can be made inexpensive.

A refrigerant path 10f (temperature adjusting path) is formed in each partial electrode plate 12p. Though not shown in detail, those refrigerant paths 10f are connected to the refrigerant reservoirs 16f (see FIG. 9), respectively. The refrigerant paths 10c, 10d, 10e of those electrode plates 11, 12M other than the end-electrode plates 12L, 12R are connected to the refrigerant reservoirs 16f without through the refrigerant paths 10f, respectively.

FIG. 16 shows the third embodiment of the present invention. The third embodiment is a modified embodiment of the first embodiment (FIGS. 1 and 2) relating to a fundamental construction of the present invention.

In the third embodiment, the casing 19 of the processing head 1 is extended leftward and rightward and the respective electrode plates 11, 12 within the casing 19 are arranged in side-by-side relation in a direction orthogonal to the left and right directions, i.e., moving direction of the workpiece W, as in the first embodiment.

On the other hand, in the third embodiment, the electrode plates 11, 12 are slanted at an angle of θ (θ < (π / 2)) with respect to their side-by-side arranging directions, i.e., left and right directions unlike in the first embodiment. They are slanted at an angle of ((π / 2) - θ) with respect to the moving direction (back and forth directions) of the workpiece W. Accordingly, the extending direction of the electrode-to-electrode slit 10a is also slanted at an angle of ((π / 2) - θ) with respect to the moving direction of the workpiece W. In the third embodiment, although the electrode plates 11, 12 and the electrode-to-electrode slit 10a are slanted rightward with respect to the front direction (above in FIG. 16), they may be slanted leftward.

As indicated by the one-dot chain line of FIG. 16, the front end part (upper end in FIG. 16) of a certain electrode-to-electrode slit 10a and the rear end part (lower end in FIG. 16) of the electrode-to-electrode adjacent immediately thereto are located on the same linear line along the moving directions, i.e., back and forth directions, of the workpiece W. In other words, the position in the left and right directions of the front end part of the above-mentioned certain electrode-to-electrode slit 10a and the position in the left and right directions of the rear end part of the electrode-to-electrode slit 10a adjacent thereto are aligned. Accordingly, in the plasma processing apparatus M1 of the third embodiment, the slit group 100 satisfies the following expression;

$$L \times \cos \theta = (t + d) \times \operatorname{cosec} \theta \qquad \dots \dots (1)$$

Wherein L represents the length of the electrode-to-electrode slit 10a, t, the thickness of the electrode plates 11, 12 (interval between the adjacent electrode-to-electrode slits) and d, the width of the electrode-to-electrode slit 10a (interval between the adjacent electrode plates 11, 12), respectively.

Although not shown, a slit-like flow rectification plate 23a (see FIG. 2) of the flow rectification module 20 disposed on the upper side of the electrode module 10 is also slanted in match with the electrode-to-electrode slit 10a and straightly connected to the corresponding electrode-to-electrode slit 10a over the entire length thereof.

In the above-mentioned construction, the plasmatized processing gas is sprayed onto the workpiece W. Simultaneously, the workpiece W is moved back and forth by the moving mechanism 4. At that time, each and every point of the workpiece W is slantwise moved across the area immediately under the electrode-to-electrode slit 10a and the area immediately under the electrode plates 11, 12. Owing to this arrangement, an exposing amount of the plasma gas can be equalized. Moreover, since the end parts on the reverse side in the back and forth directions of the adjacent electrode-to-electrode slits 10a are located on the same linear line in the back and forth, when the workpiece W is passed once, the exposing amount of the plasma gas can be equalized at each and every point on the workpiece W. Owing to this arrangement, the surface processing can reliably be conducted over the entire workpiece W and striped non-uniformity can reliably be prevented from occurring. Especially, under the circumstance of generally normal pressure, striped irregularity tends to occur because gas is hardly dispersed. The above-mentioned-arrangement can effectively prevent such an occurrence of irregularity.

The respective electrode plates 11, 12 can reliably be shortened irrespective of the size of the workpiece W as in the first embodiment.

Two electrode-to-electrode slits 10a, 10a whose end parts on the reverse side in the back and forth directions are to be aligned on the same linear line L 1 in the back and forth directions are not limited to those which are directly adjacent with each other. They may be arranged alternately or every several electrode-to-electrode slits. That is, it is good enough if the slit group 100 satisfies the following expression which is obtained by generalizing the above-mentioned expression (1);

$$L \times \cos\theta = n \times (t + d) \times \operatorname{cosec}\theta \qquad \dots\dots(2)$$

wherein n represents an integer of 1 or larger. In FIG. 16 (those adjacent to each other at intervals of one), n = 1.

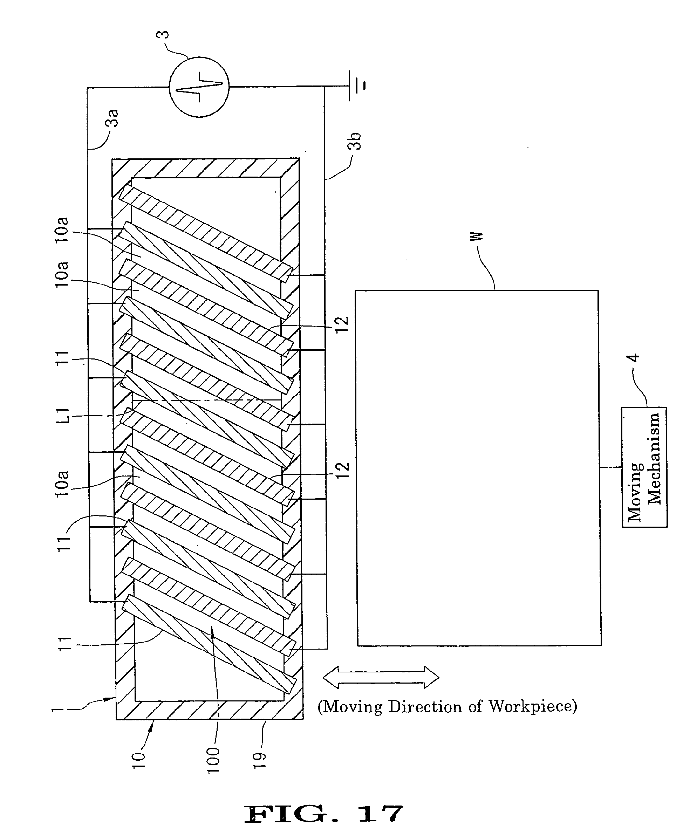

FIG. 17 shows the electrode module 10 where n = 2 is satisfied in the above-mentioned expression (2). In this electrode module 10, the respective electrode plates 11, 12 and thus, the electrode-to-electrode slits 10a are more slanted than those in FIG. 16. The front end part of a certain electrode-to-electrode slit 10a and the rear end part of the electrode-to-electrode slit 10a which is adjacent thereto at one interval (i.e., the slit next to the adjacent slit) are aligned on the same linear line L1 in the back and forth directions.

As shown in FIG. 18, even if the respective electrode plates 11, 12 are orthogonal to the side-by-side arranging direction and the construction of the electrode module itself is same as the one in FIG. 1, the electrode plates 11, 12 and thus, the electrode-to-electrode slit 10a can be slanted by diagonally arranging the entirety.

In FIG. 18, the entire processing head 1 is slanted by an angle θ' (= (π / 2) - θ) in the clockwise direction in a plan view. Owing to this arrangement, the longitudinal direction of the electrode module 10 is slanted by the angle θ' with respect to the left and right direction. Also, the electrode plates 11, 12 and thus, the electrode-to-electrode slit 10a are slanted by the angle θ' with respect to the back and forth directions, i.e., moving direction of the workpiece W. The front end part of a certain electrode-to-electrode slit 10a and the rear end part of the electrode-to-electrode slit 10a immediately adjacent thereto in the right direction are located on the same linear line L1 in the back and forth directions. In the electrode module 10 of FIG. 18, the following expression, which is equivalent to the expression (2), is satisfied.

$$L \times \cos(\pi / 2 - \theta') = n \times (t + d) \times \sin(\pi / 2 - \theta') \qquad \dots\dots(3)$$

L, t, d and n of the expression (3) are same as defined in the expression (2). In case of the electrode module 10 of FIG. 18, n = 1. Of course, the electrode module 10 may be slanted such that n becomes an integer of 2 or larger. The electrode module 10 may be slanted in the counterclockwise direction instead of the clockwise direction in a plan view.

Also in the slanting construction as shown in FIGS. 16 through 18, a multi-stage of the slit groups 100 may be arranged on the front and rear sides.

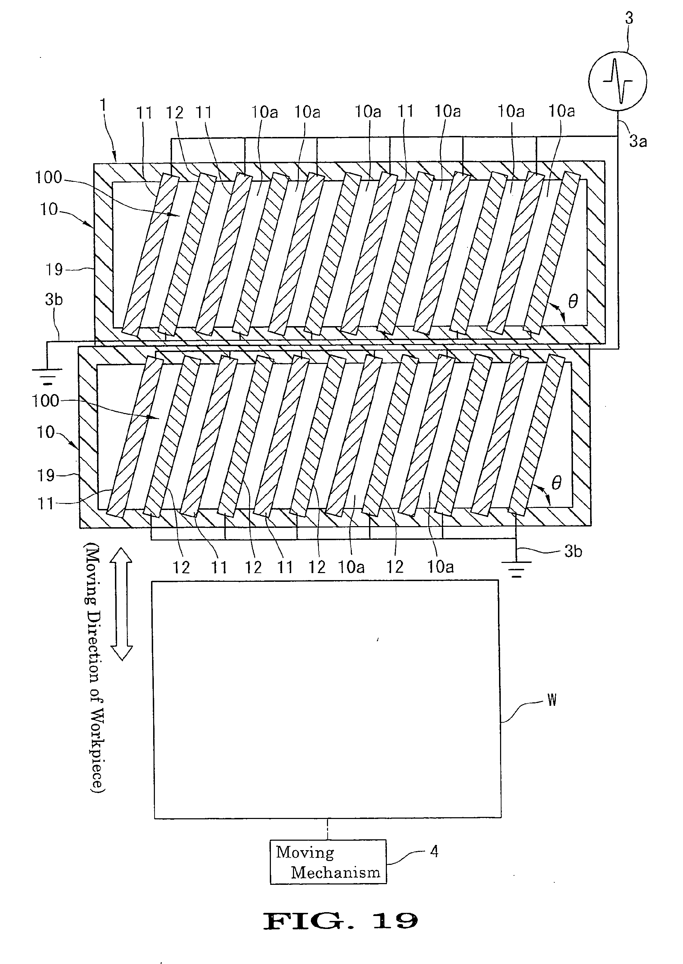

For example, a processing head shown in FIG. 19 includes two electrode modules arranged on the front and rear sides and two stages of slit groups arranged on the front and rear sides. The casing 19 of each electrode module 10 is extended in the left and right directions orthogonal to the workpiece moving direction and electrode plates 11, 12 are arranged in side-by-side relation leftward and rightward within the casing 19 as in the one shown in FIG. 16. Those electrode plates 11, 12 and thus, the electrode-to-electrode slits 10a are slanted at a predetermined angle θ with respect to the side-by-side arranging directions in the left and right directions. The corresponding slits 10a of the electrode modules 10 arranged on the front and rear sides are deviated by a half pitch in the left and right directions. Though not shown, a gas flow rectification module 20 is installed on the upper side of each electrode module 10.

In FIG. 19, although the inclination angle θ is set to be a value which satisfies the expression (1) (that is, in case of n = 1 of the expression (2)), it may be set to a value which satisfies n ≥ 2 of the expression (2).

According to such a two-stage slanting construction, surface processing can be conducted in a more uniformized manner. Moreover, the respective electrode plates 11, 12 can be made smaller in size.

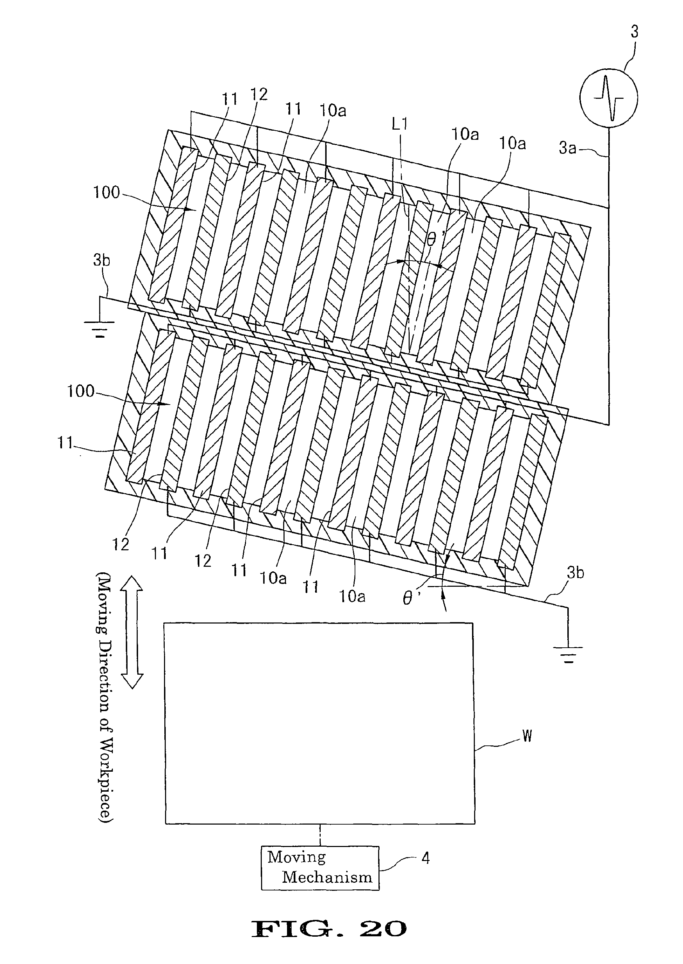

FIG. 20 shows another embodiment in which the slanting electrode module 10 of FIG. 18 is formed in a multi-stage construction. A processing head of this embodiment includes two slanting electrode modules 10, which modules 10 are same as those of FIG. 18, arranged on the front and rear sides. The longitudinal direction of each module 10 is extended in a direction at an angle θ' with respect to the left and right directions. The electrode plates 11, 12 and thus, the electrode-to-electrode slits 10a are arranged in side-by-side relation in the longitudinal direction of the electrode module 10 and directed in a direction orthogonal to the longitudinal direction of the electrode module 10, i.e., direction forming the angle θ' with respect to the moving directions of the workpiece W.

Although the electrode modules 10 arranged on the front and rear sides are slightly deviated in the left and right directions, they may be arranged in a non-deviating manner.

Fig. 21 shows still another embodiment in which the apparatus of the second embodiment (FIGS. 5 through 14) are formed in a slanting construction.

A processing head 1 according to this embodiment comprises a large number of electrode modules 10 laterally arranged in side-by-side relation in two stages on the front and rear sides. The two stages of slit groups 100 arranged on the front and rear sides are constituted by this arrangement. The entire processing head 1 is slanted by an angle θ' in the clockwise direction in a plan view. Owing to this arrangement, the side-by-side arranging directions of the electrode modules 10 are slanted at an angle θ' with respect to the left and right directions (directions orthogonal to the moving directions of the workpiece W). The respective electrode plates 11, 12 of each electrode module 10 and thus, the respective slits 10a of each slit group 100 are orthogonal to the side-by-side arranging directions and therefore, slanted in a direction forming the angle θ' with respect to the back and forth directions, i.e., moving directions of the workpiece W.

This inclination angle θ' is set such that the following expression which is equivalent to the previously-mentioned expressions (2) and (3) is satisfied;

$$\theta' = \tan^{-1}\left(n \times P\,/\,L\right) \qquad\qquad \ldots\ldots(5)$$

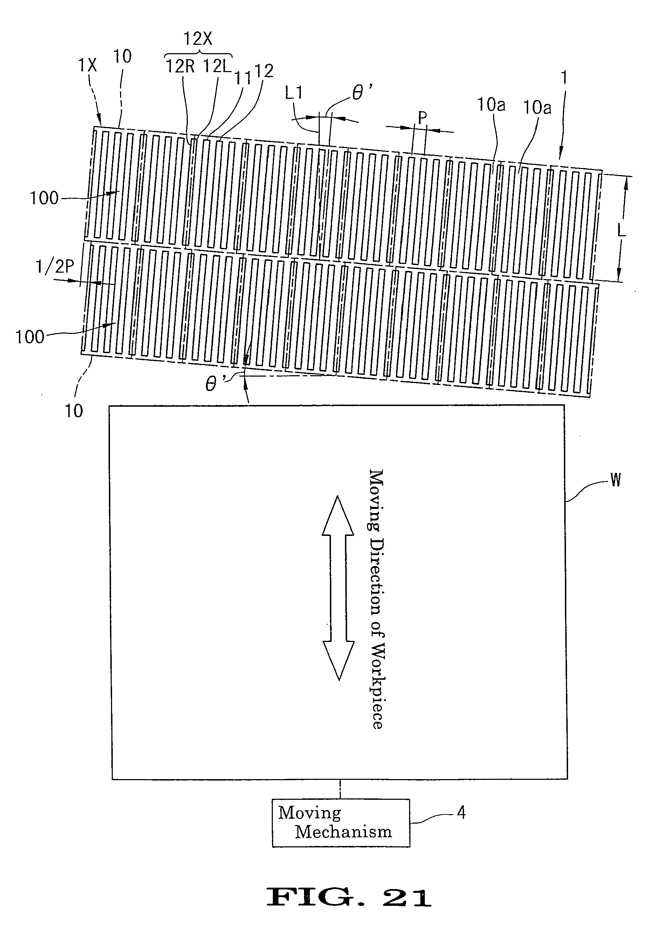

In the above expression (5), P represents a pitch (for example, P = 12 mm) between the electrode plates 11, 12 and the electrode-to-electrode slits 10a, L, the length (for example, L = 300 mm) of the electrode-to-electrode slits 10a and n, an integer of 1 or larger, respectively. In the apparatus of FIG. 21, n = 1. Owing to this arrangement, in the two electrode slits 10a adjacent in the left and right directions, the front end part of the left-side electrode slit 10a and the rear end part of the right-side electrode slit 10a are located on the same linear line L along the moving directions of the workpiece W in the back and forth direction.

Although the specific construction of the electrode module 10 is same as that of the second embodiment shown in FIGS. 6 through 13, the end-electrode plates 12L, 12R may be constructed in the same manner as in the modified embodiment of the second embodiment shown in FIG. 15 instead of the one according to the second embodiment. Although the front-side stage and the rear-side stage are deviated by a half pitch (P/2) in the left and right directions, this deviation is not necessarily required. The inclination angle θ' may be set such that n ≥ 2 is satisfied in the expression (1). The electrode modules 10 may be slanted in the counterclockwise direction instead of clockwise direction in a plan view.

In the embodiments so far described, the processing head 1 is fixed to the support base and non-movable. However, it is also accepted that the processing head 1 is relatively swung in a direction intersecting with the moving directions of the workpiece W.

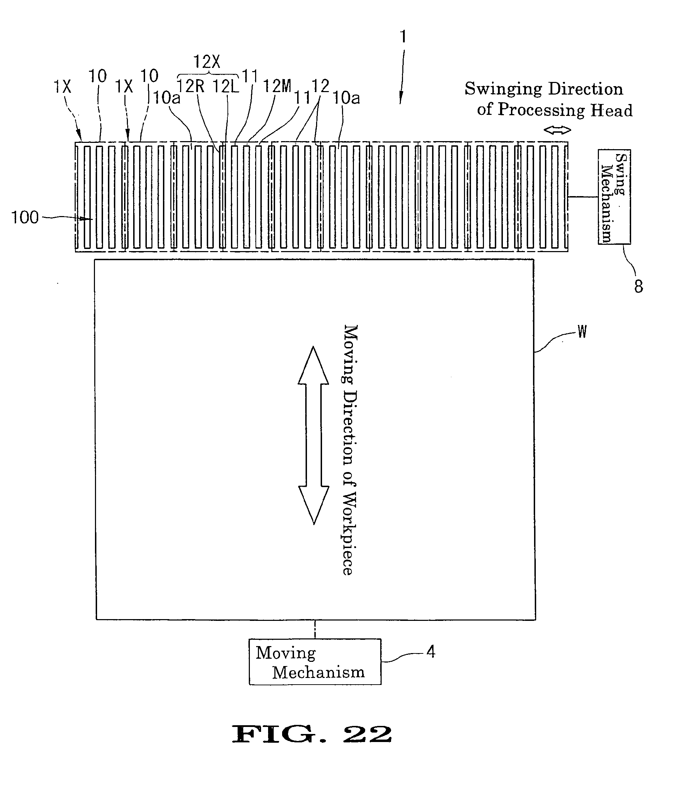

That is, in the fourth embodiment shown in FIG. 22, a processing head 1 composed of a single stage of module units 1X arranged in side-by-side relation in the left and right directions are slidably supported on a support base (not shown) in the left and right directions. A swing mechanism 8 is connected to this processing head 1. The swing mechanism 8 comprises, for example, a reciprocal actuator, a turnable actuator, a converting mechanism for converting the turning motion into a reciprocal motion, and the like, and is capable of swinging the entire processing head 1 in the left and right directions. At the time of plasma processing, the workpiece W is moved back and forth by the moving mechanism 4 and the processing head 1 is swung in the left and right directions (direction orthogonal to the moving direction of the workpiece W). In the meantime, the processing gas is plasmatized and sprayed onto the workpiece W. Owing to this arrangement, even if the extending direction of the respective slits is in parallel with the moving directions of the workpiece W, striped non-uniformity of processing can be prevented from occurring and uniformity of the surface processing can be enhanced.

The swinging amplitude caused by the swing mechanism 8 is, for example, 1/2 of the pitch P between the electrode plates and the electrode-to-electrode slits 10a, but actually, the singing amplitude is desirably optimized in a range larger than P/2 in view of positional accuracy and acceleration/deceleration. Owing to this arrangement, the striped non-uniformity can reliably be eliminated.

The swinging cycle is optimized in accordance with the moving speed of the workpiece W caused by the moving mechanism 4. Specifically, the swinging cycle is set such that the processing head 1 is just swung naturally (desirously plural times) during the time the workpiece W is moved by a distance equal to the length portion of the slit 10a. Owing to this arrangement, non-uniformity caused by swinging motion itself can be prevented from occurring.

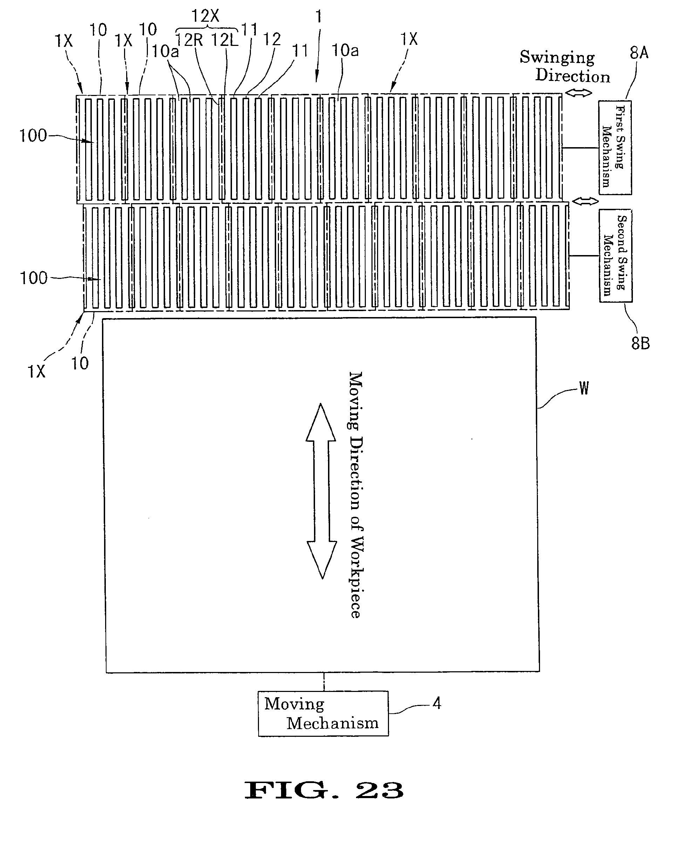

FIG. 23 shows a modified embodiment of the fourth embodiment equipped with the above-mentioned swing mechanism. A processing head 1 of this modified embodiment comprises two stages of module units 1X arranged in side-by-side relation in the left and right directions on the front and rear sides. The entire module unit 1X on the front-side (upper side in FIG. 23) stage is supported by a support base, not shown, such that the unit 1X is slidable in the left and right directions as one unit. Also, the entire module unit 1X on the rear-side (lower side in FIG. 23) stage is supported by the support base such that the unit 1X is slidable in the left and right directions as one unit but separately from the front-side stage. The front-side stage module unit 1X is connected with a first swing mechanism 8A and the rear-side stage module unit 1X is connected with a second swing mechanism 8B. Those swing mechanisms 8A, 8B have the same construction as the above-mentioned swing mechanism 8 and the module unit 1X on the corresponding stage is swung in the left and right directions respectively. Moreover, those swing mechanisms 8A, 8B are co-acted so that they are deviated in swinging phase. This phase difference $\varphi$ is, for example, $\varphi = \pi / 2$. The swinging amplitude and the cycle are same as in the above-mentioned swing mechanism 8. Owing to this arrangement, processing non-uniformity can reliably be prevented from occurring and uniformity of the surface processing can be more enhanced.

The present invention is not limited to the above-mentioned embodiments but many other embodiments can be employed.

For example, the slit group 100 is not limited to one or two stages but it may be three or more stages. In that case, the adjacent stages are preferably deviated in the side-by-side arranging directions of the slits 10a. This deviation is preferably pitch ÷ (number of stages). Especially, in case the extending direction of each slit 10a is in parallel with the moving directions of the workpiece W, the more the number of stages is increased, the more the uniformity of processing can be enhanced. In case of processing where no uniformity is required, only a single stage of the slit group 100 is good enough even if the extending direction of each slit 10a is in parallel with the moving directions of the workpiece W.

It is accepted that instead of a single slit, a plurality of apertures and short slits are arranged (extended) in a row so as to serve as "a single hole-row". It is also accepted that instead of the slit group 100, a plurality of rows each consisting of the apertures and short slits are arranged in a direction intersecting with the extending direction so as to serve as "hole-row group".

Each electrode member of the first and second electrode modules is not necessarily required to have a flat plate-like configuration but they may have a circular columnar configuration or the like.

It is also accepted that the first-end electrode member of the first electrode module and the second-end electrode member of the second electrode module are about a half in thickness of other electrode members, respectively and the combined electrode member consisting of the former and the latter is equal in thickness to other electrode members.

In the respective embodiments of a slanting construction shown in FIGS. 16 and 17, although the inclination angle $\theta$ is set such that both n = 1 and n = 2 are satisfied respectively in the expression (1), it may be set such that n = 3 or larger is satisfied. In the respective embodiments of a slanting construction shown in FIGS. 18 through 21, although the inclination angle $\theta'$ is set such that n = 1 is satisfied in the expression (4), it may be set such that n = 2 or larger is satisfied. Moreover, the inclination angle of the slanting construction is not necessarily required to satisfy the expressions (1) through (4). The inclination angle $\theta'$ may properly be set in a range from larger than 0 degree to smaller than 90 degrees.

In the embodiment of a swing mechanism shown in FIG. 22, it is also accepted that the processing head 1 is fixed and the workpiece W is swung in the left and right directions while being moved back and forth. In that case, the swing mechanism may be assembled in the moving mechanism. Of course, it is also accepted that the workpiece W is fixed and the processing head 1 is swung in the left and right directions while being moved back and forth.

The swinging direction is not limited to the side-by-side arranging directions of the slits 10a but good enough as long as this direction is intersected with the moving directions of the workpiece W. The swinging direction may also be slanted to the side-by-side arranging directions.

In the embodiment of a swing mechanism shown in FIG. 23, although the slit groups 100 (hole-row groups) are arranged in two stages, they may be three or more stages and they may be swung for each stage so that the adjacent stages are deviated in swinging phase. This phase difference $\varphi$ is, for example, $\varphi = \pi / n$ wherein n is the number of stages. However, the present invention is not limited to this. It may properly be set in accordance with the processing conditions, etc. In case of three or more stages, the swing mechanism connected to one of the adjacent stages is referred to as the "first swing mechanism" as defined in claims, and the swing mechanism connected to the other stage is referred to as the "second swing mechanism". It is also accepted that the slit group (hole-row group) of one of the adjacent stages is fixed, the workpiece W is swung by the first swing mechanism and the slit group (hole-row group) of the other stage is swung in such a manner as to deviate in phase with respect to the swinging motion of the workpiece W.

The swinging operation made by the swing mechanism may also be employed in the slanting mechanism in FIGS. 16 through 21.

The present invention is applicable to those of the type that a processing gas is jetted through groups of hole rows such as slits so as to be applied to an object to be processed. The invention is not only applicable to plasma surface processing but also be applicable to electrodeless surface processing such as etching by thermal CVD, HF (hydrofluoric acid) vapor or the like. The present invention is likewise applicable to various surface processing such as ashing by ozone or the like, etching by $CF_4$ or the like, film deposition (CVD), cleaning, surface modification (hydrophilic processing, water repellent processing) or the like.

The pressure condition of processing is not limited to the generally normal pressure but it may be under a reduced-pressure circumstance.

TEST EXAMPLE 1

One test example will now be described. Needless to say, the present invention is not limited to the following test example.

Etching was conducted under the following conditions using the same plasma processing apparatus for etching as in the second embodiment (FIGS. 5 through 14).
electrode temperature: 50 degrees C
workpiece temperature: 100 degrees C
processing gas

$CF_4$ : 200 sccm
$O_2$ : 800 sccm
$H_2O$ : 15 sccm

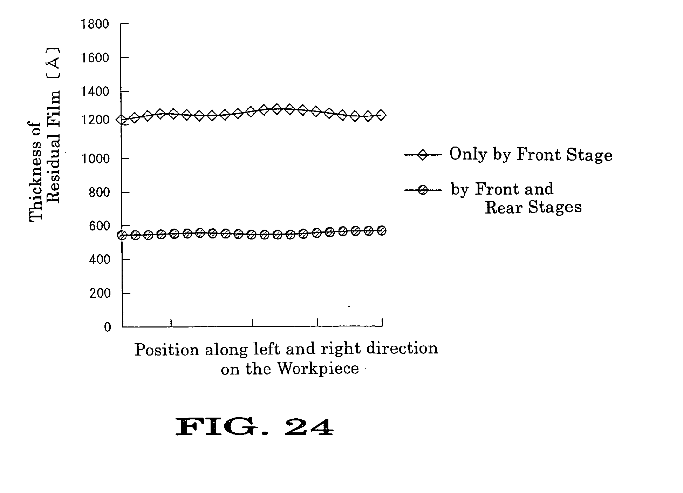

pulse frequency: 20 kHz
applying voltage: 300 V
Then, the thickness of the residual film after processed only by plasma gas coming through the front-stage slit groups (hole-row groups) and the thickness of the residual film after processed in two stages on the front and rear sides are measured over the width direction in the left and right directions of the workpiece.
The result is shown in FIG. 24. In processing only by the front stage, the film thickness was slightly non-uniform. When the processing was additionally conducted by the rear stage, the film thickness was almost uniformized.

BRIEF DESCRIPTION OF THE DRAWINGS

[FIG. 1] FIG. 1 shows the first embodiment of the present invention and is a plan sectional view of a normal pressure plasma processing apparatus taken on line I-I of FIG. 2.
[FIG. 2] FIG. 2 is a front sectional explanatory view of the normal pressure plasma processing, apparatus taken on line II-II of FIG. 1.
[FIG. 3] FIG. 3 is an explanatory view showing a processing performance by plasma gas coming through the respective electrode-to-electrode slits.
[FIG. 4] FIG. 4 is a graph showing a general relation between the working distance and the processing rate.
[FIG. 5] FIG. 5 shows the second embodiment of the present invention and is a plan view of a general construction of a normal pressure plasma processing apparatus.
[FIG. 6] FIG. 6 is a plan view of the respective electrode modules of the apparatus of FIG. 5.
[FIG. 7] FIG. 7 is a side sectional view of a module unit of the apparatus of FIG. 5, taken on line VII-VII of FIG. 8.
[FIG. 8] FIG. 8 is a front sectional view of the module unit, taken on line VIII-VIII of FIG. 7.
[FIG. 9] FIG. 9 is a plan sectional view of the module unit of the front and rear stages, taken on line IX-IX of FIG. 8.
[FIG. 10] FIG. 10 is a plan sectional view showing the detail of a connection part between a electrode plate and a filling block of the electrode module.
[FIG. 11] FIG. 11(a) is a front sectional view showing the adjacent electrode modules in the left and right directions in their separated positions, and FIG. 11(b) is a front sectional view showing the adjacent modules in their connected positions.
[FIG. 12] FIG. 12 is a front sectional view of the module unit, taken on line of XII-XII of FIG. 9.
[FIG. 13] FIG. 13 is a plan sectional view of a flow rectification module of the module unit, taken on line XIII-XIII of FIG. 8.
[FIG. 14] FIG. 14 is a graph showing the processing performance by the electrode modules on the front and rear stages in the form of positions on the workpiece and processing rates.
[FIG. 15] FIG. 15 shows a modified embodiment of the second embodiment, FIG. 15(a) is a front sectional view showing adjacent electrode modules in the left and right directions in their separated positions, and FIG. 15(b) is a front sectional view showing the adjacent modules in their connected positions.
[FIG. 16] FIG. 16 shows the third embodiment of the present invention and is a plan sectional view of a normal pressure plasma processing apparatus.
[FIG. 17] FIG. 17 is a plan sectional view showing a modified embodiment of the third embodiment.
[FIG. 18] FIG. 18 is a plan sectional view showing another modified embodiment of the third embodiment.
[FIG. 19] FIG. 19 is a plan sectional view showing another modified embodiment of the third embodiment.
[FIG. 20] FIG. 20 is a plan sectional view showing another modified embodiment of the third embodiment.
[FIG. 21] FIG. 21 is a plan view showing an embodiment in which components of the subject of the third embodiment is combined with the apparatus of the second embodiment.
[FIG. 22] FIG. 22 is a plan view showing the fourth embodiment of the present invention.
[FIG. 23] FIG. 23 is a plan view showing a modified embodiment of the fourth embodiment.
[FIG. 24] FIG. 24 is a graph showing the result of the test example 1.

REFERENCE NUMERALS

| | | |
|---|---|---|
| M | normal pressure plasma processing apparatus (surface processing apparatus) |
| W | workpiece (object to be processed) |
| 1 | plasma processing head (processor) |
| 1X | module unit |
| 10 | first and second electrode modules |
| 10a | slit (hole row, gap serving as a plasmatizing space) |
| 100 | slit group (hole-row group) |
| 11 | electrode plate (plate-like electrode member) of a hot electrode |
| 12 | electrode plate (plate-like electrode member) of an earth electrode |
| 12L, 12R | end-electrode plate (first or second end electrode member) |
| 12X | combined electrode plate (combined electrode member) |
| 12f, 12k | first or second enlarged-thickness part |
| 12g, 12h | first or second reduced-thickness part |
| 12p | partial electrode plate (partial electrode plate) |
| 12a, 12b, 12c, 12f | refrigerant path (temperature adjusting path) |
| 20 | flow rectification module |
| 4 | moving mechanism |
| 8 | swing mechanism |
| 8A | first swing mechanism |
| 8B | second swing mechanism |

**Claims**

1.  An apparatus for processing the surface of an object to be processed by spraying a processing gas onto said object, said apparatus comprising:

    a processor having a group of hole-rows composed of hole-rows each extending in one direction and arranged each other in a side-by-side relation at equal pitches in a direction intersecting with the extending direction of each of said hole-rows, the processing gas being blown through each of said hole-rows; and
    a moving mechanism for relatively moving said processor in a direction intersecting with the side-by-side arranging direction with respect to said object.

2.  A surface processing apparatus according to claim 1, wherein the relatively moving direction is along the extending direction of each of said hole-rows.

3.  A surface processing apparatus according to claim 1, wherein the extending direction of each of said hole-rows and the side-by-side arranging direction of said hole-rows are orthogonal to each other and the relatively moving direction is along the extending direction.

4.  A surface processing apparatus according to claim 1, wherein the extending direction of each of said hole-rows is slanted with respect to the relatively moving direction.

5.  A surface processing apparatus according to claim 1, wherein the extending direction of each of said hole-rows is slanted with respect to the relatively moving direction and the side-by-side arranging direction of said hole-rows is orthogonal to the relatively moving direction.

6.  A surface processing apparatus according to claim 1, wherein the extending direction of each of said hole-rows is slanted with respect to the relatively moving direction and the side-by-side arranging direction of said hole-rows is orthogonal to the extending direction.

7.  A surface processing apparatus according to claim 4, wherein one end part in the extending direction of one of two hole-rows disposed adjacent or every predetermined hole-row(s) of all said hole-rows is located on a same linear line along the relatively moving direction as the other end part in the extending direction of the other of said two hole-rows.

8. A surface processing apparatus according to claim 1, wherein said pitches each are set to be generally equal to an effective processing width when a distance between said hole-rows and said object is set to a neighborhood of the upper limit of an effective range.

9. A surface processing apparatus according to claim 1, further comprising a swing mechanism for relatively swinging said processor in a direction intersecting with the relatively moving direction with respect to said object.

10. A surface processing apparatus according to claim 1, wherein said processor includes a plurality of stages of said group of hole-rows in the extending direction, and hole-rows of one of two adjacent stages of said plurality of stages are deviated from hole-rows of the other of said two stages in the side-by-side arranging direction.

11. A surface processing apparatus according to claim 10, wherein an amount of said deviation is 1/n (n is the number of stages of the hole-row groups) of said pitch.

12. A surface processing apparatus according to claim 1, wherein said processor includes a plurality of stages of said hole-row groups in the extending direction, and
said apparatus further comprises:

a first swing mechanism which relatively swings a hole-row group of one of two adjacent stages of said plurality stages in a direction intersecting with the relatively moving direction with respect to said object; and
a second swing mechanism which relatively swings a hole-row group of the other of said two stages in the same direction as the relatively swinging direction of said first swing mechanism with the phase shifted from that of said first swing mechanism.

13. A surface processing apparatus according to claim 1, wherein said processor includes a plurality of electrode members arranged in a side-by-side relation at equal pitches, a slit-like gap as one of said hole-rows is formed between two adjacent electrode members of said plurality of electrode members,
a processing gas for plasma processing said object being passed through said gap.

14. A surface processing apparatus according to claim 13, wherein said processor includes a plurality of electrode modules separatably connected in the side-by-side arranging direction of said hole-rows,
each of said electrode modules includes a plurality of electrode members arranged in a side-by-side relation at equal pitches and constitutes a part of said hole-row group.

15. A surface processing apparatus according to claim 14, wherein said adjacent two electrode modules each have an end electrode member arranged at mutually opposing ends, said end electrode member of one of said two electrode modules is put together with said end electrode member of the other of said two electrode modules so that these end electrode members constitute a single combined electrode member,
said combined electrode member being equal in thickness to the other respective electrode members of said adjacent two electrode modules.

16. A surface processing apparatus according to claim 1, wherein said processor includes a flow rectification path for uniformizing processing gas, and said hole-rows are continuous with said flow rectification path such that said hole-rows are branched.

17. A surface processing apparatus according to claim 14, wherein said processor includes a plurality of module units separatably connected in the side-by-side arranging direction, each of said module units comprises said electrode module and a flow rectification module connected to said electrode module, said flow rectification module includes a flow rectification path for uniformizing processing gas, and hole-rows of said electrode module are connected to said flow rectification path such that said hole-rows are blanched in each of said module unit.

18. A surface processing method comprising the step of:

blowing a processing gas through each of a plurality of hole-rows arranged in a side-by-side relation in a direction at equal pitches on a processor so as to be sprayed onto an object to be processed while relatively moving said processor in a direction intersecting with the side-by-side arranging direction with respect to said object.

**19.** A surface processing method according to claim 18, wherein the step includes blowing said processing gas while relatively moving said object along the extending direction of each of said hole rows.

**20.** A surface processing method according to claim 18, wherein the step includes blowing said processing gas while relatively slantwise moving said object with respect to the extending direction of each of said hole-rows.

**21.** A surface processing method according to claim 18, wherein said pitch is set to be approximately equal to an effective processing width when a distance between said hole-rows and said object is in a neighborhood of the upper limit of an effective range and the step includes processing under such a condition that said distance is in a neighborhood of the upper limit of said effective range.

**22.** A surface processing method according to claim 18, wherein said processor is constituted by arranging a plurality of stages of hole-row groups composed of hole-rows having said equal pitches in the extending direction of each of said hole-rows and the adjacent two stages of said hole-row groups are deviated in the side-by-side arranging direction,
said relative movement being conducted with respect to said plurality of stages of said hole-row groups altogether.

**23.** A surface processing method according to claim 18, wherein the step includes blowing said processing gas while further relatively swinging said processor in a direction intersecting with said relatively moving direction with respect to said object.

**24.** A surface processing method according to claim 23, wherein a swinging width of said swinging motion is set to be 1/2 or slightly larger than 1/2 of said pitch.

**25.** A surface processing method according to claim 23, wherein the cycle of said swinging motion is set to be 1/m times (m: integer) of a required time for said object to relatively move by a distance corresponding to the length of said hole-row.

**26.** A surface processing method according to claim 18, wherein said processor is constituted by arranging a plurality of stages of hole-row groups composed of hole-rows having said equal pitches in the extending direction of each of said hole-rows,
in parallel with said relative movement, said hole-rows of the adjacent stages being relatively swung in a way as to be deviated in phase in a direction intersecting with said relatively moving direction with respect to said object.

**27.** An apparatus for plasma processing an object to be processed by jetting a processing gas through a plasmatizing space and applying the processing gas onto an object arranged outside said plasmatizing space, said apparatus comprising:

a first electrode module and a second electrode module arranged each other in side-by-side relation in one direction,
said first and second electrode modules each include a plurality of electrode members arranged in side-by-side relation in the same direction as the side-by-side arranging direction of said first and second electrode modules, and a support part for connecting and supporting said electrode members,
a gap serving as said plasmatizing space is formed between every adjacent electrode members,
a first end electrode member of all said electrode members of said first electrode module located at an end on said second electrode module side and a second end electrode member of all said electrode members of said second electrode module located at an end on said first electrode module side are combined to form a single combined electrode member, and
electrode members other than said first end electrode member of said first electrode module, said combined electrode member and electrode members other than said second end electrode member of said second electrode module are arranged at equal pitches with respect to one another.

**28.** A plasma processing apparatus according to claim 27, wherein said first end electrode member and said second end electrode member, i.e. said combined electrode member, are electrically grounded.

**29.** A plasma processing apparatus according to claim 27, wherein in said first electrode module, said first end electrode member integrally includes a first enlarged-thickness part protruding toward said second electrode module, and a first reduced-thickness part which is smaller in thickness than said first enlarged-thickness part and withdrawn to the opposite side of said second electrode module side,

in said second electrode module, said second end electrode member integrally includes a second reduced-thickness part which is withdrawn to the opposite side of said first electrode module side and a second enlarged-thickness part which is bigger in thickness than said second enlarged-thickness part and protruding toward said first electrode module, and

in said combined electrode member, said first enlarged-thickness part and said second reduced-thickness part are put together with each other and said first reduced-thickness part and said second enlarged-thickness part are put together with each other.

30. A plasma processing apparatus according to claim 29, wherein a temperature adjusting path is formed within said first enlarged-thickness part and said path allows a fluid for adjusting the temperature of said first end electrode member to pass therethrough.

31. A plasma processing apparatus according to claim 27, wherein said combined electrode member is divided into a plurality of partial electrode members along a width direction intersecting with the side-by-side arranging direction of said first and second electrode modules, one of the adjacent partial electrode members is supported by said support part of said first electrode module thereby constituting said first end electrode member, and the other of the adjacent partial electrode members is supported by said support part of said second electrode module thereby constituting said second end electrode member.

32. A plasma processing apparatus according to claim 31, wherein a temperature adjusting path is formed within said partial electrode member and said path is allowed a fluid for adjusting the temperature to pass therethrough.

33. A plasma processing apparatus according to claim 27, wherein the respective electrode members of said first and second electrode modules each have a plate-like configuration intersecting with the side-by-side arranging direction of said first and second electrode modules, the plate-like respective electrode members other than said first end electrode member of said first electrode module, said plate-like combined electrode member and said plate-like respective electrode members other than said second end electrode member of said second electrode module are equal in thickness.

**FIG. 1**

FIG. 2

Processing Gas

Moving Mechanism

Position along left and right direction on the Workpiece

## FIG. 3

## FIG. 4

**FIG. 5**

FIG. 6

FIG. 7

FIG. 8

**FIG. 9**

14

14a, 14b, 14c

14e

18

18

66

65

10a

66

10a

10c, 10d, 10e

13

13

11, 12

# FIG. 10

**FIG. 11(a)**

**FIG. 11(b)**

**FIG. 12**

**FIG. 13**

FIG. 14

**FIG. 15(a)**

**FIG. 15(b)**

## FIG. 16

**FIG. 17**

**FIG. 18**

## FIG. 19

**FIG. 20**

**FIG. 21**

**FIG. 22**

**FIG. 23**

**FIG. 24**

## INTERNATIONAL SEARCH REPORT

| International application No. |
| --- |
| PCT/JP2004/008899 |

A. CLASSIFICATION OF SUBJECT MATTER
    Int.Cl⁷  H01L21/205, H01L21/31, C23C16/455, H05H1/46

According to International Patent Classification (IPC) or to both national classification and IPC

B. FIELDS SEARCHED

Minimum documentation searched (classification system followed by classification symbols)
    Int.Cl⁷  H01L21/205, H01L21/31, C23C16/455, H05H1/46

Documentation searched other than minimum documentation to the extent that such documents are included in the fields searched
    Jitsuyo Shinan Koho          1922–1996   Toroku Jitsuyo Shinan Koho     1994–2004
    Kokai Jitsuyo Shinan Koho    1971–2004   Jitsuyo Shinan Toroku Koho     1996–2004

Electronic data base consulted during the international search (name of data base and, where practicable, search terms used)

C. DOCUMENTS CONSIDERED TO BE RELEVANT

| Category* | Citation of document, with indication, where appropriate, of the relevant passages | Relevant to claim No. |
| --- | --- | --- |
| Y  A | JP 2002-155371 A  (Sekisui Chemical Co., Ltd.), 31 May, 2002 (31.05.02), Par. Nos. [0063] to [0069] (Family: none) | 1-3,8,9,16, 18,19,21, 23-25  4-7,10-15, 17,20,22,26 |
| Y  A | JP 10-226886 A  (Ebara Corp.), 25 August, 1998 (25.08.98), Par. Nos. [0014] to [0019] & EP 853138 A1          & US 6132512 A & KR 98070372 A | 1-3,8,9,16, 18,19,21, 23-25  4-7,10-15, 17,20,22,26 |
| A | JP 2002-94221 A  (Sekisui Chemical Co., Ltd.), 29 March, 2002 (29.03.02), Par. No. [0037] (Family: none) | 1-26 |

☒ Further documents are listed in the continuation of Box C.          ☐ See patent family annex.

| * | Special categories of cited documents: | "T" | later document published after the international filing date or priority date and not in conflict with the application but cited to understand the principle or theory underlying the invention |
| --- | --- | --- | --- |
| "A" | document defining the general state of the art which is not considered to be of particular relevance | | |
| "E" | earlier application or patent but published on or after the international filing date | "X" | document of particular relevance; the claimed invention cannot be considered novel or cannot be considered to involve an inventive step when the document is taken alone |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | | |
| "P" | document published prior to the international filing date but later than the priority date claimed | "&" | document member of the same patent family |

| Date of the actual completion of the international search | Date of mailing of the international search report |
| --- | --- |
| 22 September, 2004 (22.09.04) | 12 October, 2004 (12.10.04) |

| Name and mailing address of the ISA/ | Authorized officer |
| --- | --- |
| Japanese Patent Office | |
| Facsimile No. | Telephone No. |

Form PCT/ISA/210 (second sheet) (January 2004)

46

| INTERNATIONAL SEARCH REPORT | International application No. |
|---|---|
| | PCT/JP2004/008899 |

C (Continuation). DOCUMENTS CONSIDERED TO BE RELEVANT

| Category* | Citation of document, with indication, where appropriate, of the relevant passages | Relevant to claim No. |
|---|---|---|
| A | JP 2003-92292 A (Sumitomo Precision Products Co., Ltd.), 28 March, 2003 (28.03.03), Claims 1, 8; Par. Nos. [0037] to [0052] (Family: none) | 1-26 |
| Y A | JP 2000-109979 A (Tokujiro OKUI), 18 April, 2000 (18.04.00), Par. Nos. [0009] to [0012]; Figs. 1, 2(a) to (e), 3, 4 (Family: none) | 27,28 29-33 |
| Y A | JP 2001-274101 A (Mitsubishi Heavy Industries, Ltd.), 05 October, 2001 (05.10.01), Par. No. [0037] (Family: none) | 27,28 29-33 |
| P,Y | JP 2003-188104 A (Fuji Xerox Co., Ltd.), 04 July, 2003 (04.07.03), Par. No. [0064] (Family: none) | 27,28 |
| A | JP 8-222548 A (Hitachi, Ltd.), 30 August, 1996 (30.08.96), Par. Nos. [0021], [0022], [0026]; Figs. 7, 8, 12 (Family: none) | 27-33 |
| P,A | JP 2003-249492 A (Konica Corp.), 05 September, 2003 (05.09.03), Par. Nos. [0031] to [0039]; Fig. 1 (Family: none) | 27-33 |

Form PCT/ISA/210 (continuation of second sheet) (January 2004)

**INTERNATIONAL SEARCH REPORT**

International application No.

PCT/JP2004/008899

**Box No. II      Observations where certain claims were found unsearchable (Continuation of item 2 of first sheet)**

This international search report has not been established in respect of certain claims under Article 17(2)(a) for the following reasons:

1. ☐ Claims Nos.:
   because they relate to subject matter not required to be searched by this Authority, namely:

2. ☐ Claims Nos.:
   because they relate to parts of the international application that do not comply with the prescribed requirements to such an extent that no meaningful international search can be carried out, specifically:

3. ☐ Claims Nos.:
   because they are dependent claims and are not drafted in accordance with the second and third sentences of Rule 6.4(a).

**Box No. III      Observations where unity of invention is lacking (Continuation of item 3 of first sheet)**

This International Searching Authority found multiple inventions in this international application, as follows:
    As shown in extra sheet, this international application is divided into
two groups of inventions.

    (Continued to extra sheet.)

1. ☐ As all required additional search fees were timely paid by the applicant, this international search report covers all searchable claims.

2. ☒ As all searchable claims could be searched without effort justifying an additional fee, this Authority did not invite payment of any additional fee.

3. ☐ As only some of the required additional search fees were timely paid by the applicant, this international search report covers only those claims for which fees were paid, specifically claims Nos.:

4. ☐ No required additional search fees were timely paid by the applicant.   Consequently, this international search report is restricted to the invention first mentioned in the claims; it is covered by claims Nos.:

**Remark on Protest**      ☐ The additional search fees were accompanied by the applicant's protest.

☐ No protest accompanied the payment of additional search fees.

Form PCT/ISA/210 (continuation of first sheet (2)) (January 2004)

48

**INTERNATIONAL SEARCH REPORT**

International application No.

PCT/JP2004/008899

Continuation of Box No.III of continuation of first sheet(2)

The inventions of claims 1-26 relate to a surface treatment device "including: a group of holes extending in one direction and arranged at an identical pitch in the direction intersecting the extension direction; a processing section for blowing a treatment gas through the holes; and a moving mechanism for relatively moving the processing section with respect to a work to be treated in the direction intersecting the hole arrangement direction".

The inventions of claims 27-33 relate to a plasma treatment device characterized by the configuration of a plasma generation section as follows. "The device includes a first electrode module and a second electrode module arranged in one direction. Each of the first electrode module and the second electrode module includes: a plurality of electrode members arranged in the same direction as the arrangement direction of the electrode modules; and a support member connecting and supporting the electrode members. Between adjacent electrode members, there is formed a void for forming a plasma space. Among the electrode members of the first electrode module, the first end electrode member arranged at the end of the second electrode module side is combined with the second electrode member arranged at the end of the first electrode module side among the electrode members of the second electrode module, thereby constituting a combined electrode member. The electrode members of the first electrode module excluding the first end electrode member and the electrode members of the second electrode module excluding the second end electrode member are arranged at an identical pitch."

Form PCT/ISA/210 (extra sheet) (January 2004)